# EUROPEAN PATENT APPLICATION

(11) **EP 4 312 270 A1**
(43) Date of publication of application: **31.01.2024**
(21) Application number: 23187705.1
(22) Date of filing: 25.07.2023
(51) Int. Cl.: H01L 25/075, H01L 33/00, H01L 33/62

(54) **DISPLAY DEVICE AND MANUFACTURING METHOD OF DISPLAY DEVICE**

(30) Priority: 28.07.2022 KR 20220094228
(71) Applicant: Samsung Display Co., Ltd., Yongin-si, Gyeonggi-do 17113 (KR)
(72) Inventor: LEE, Seung Kyu, 17113 Yongin-si (KR); AHN, Jung Hyun, 17113 Yongin-si (KR)
(74) Representative: Walaski, Jan Filip

(57) **Abstract**

A display device includes a first pixel electrode disposed on a base layer, a first insulating layer disposed on the first pixel electrode and including an opening exposing the first pixel electrode, a first electrode and a second electrode disposed on the first insulating layer and spaced apart from each other with the opening disposed between the first electrode and the second electrode, a light emitting element disposed in the opening and including a first end portion electrically contacting the first pixel electrode and a second end portion, a second insulating layer covering the first insulating layer, the first electrode, and the second electrode and exposing the second end portion of the light emitting element, and a second pixel electrode disposed on the second insulating layer and electrically contacting the second end portion of the light emitting element.

## Description

### CROSS-REFERENCE TO RELATED APPLICATION(S)

This application claims priority to Korean patent application No. 10-2022-0094228, filed on July 28, 2022, in the Korean Intellectual Property Office (KIPO).

### BACKGROUND

### 1. Technical Field

The disclosure generally relates to a display device and a manufacturing method of a display device.

### 2. Description of Related Art

As interest in information displays and demand for portable information media increase, research and commercialization has focused on display devices.

### SUMMARY

Embodiments provide a display device and a manufacturing method of a display device, which can improve light emission efficiency.

In accordance with an aspect of the disclosure, a display device may include a first pixel electrode disposed on a base layer, a first insulating layer disposed on the first pixel electrode and including an opening exposing the first pixel electrode, a first electrode and a second electrode disposed on the first insulating layer and spaced apart from each other with the opening disposed between the first electrode and the second electrode, a light emitting element disposed in the opening and including a first end portion electrically contacting the first pixel electrode and a second end portion, a second insulating layer covering the first insulating layer, the first electrode, and the second electrode and exposing the second end portion of the light emitting element, and a second pixel electrode disposed on the second insulating layer and electrically contacting the second end portion of the light emitting element.

The light emitting element may include an n-type semiconductor layer, an active layer, and a p-type semiconductor layer, which are sequentially stacked. The p-type semiconductor layer may electrically contact the second pixel electrode.

The first pixel electrode may be a cathode electrode, and the second pixel electrode may be an anode electrode.

The light emitting element may further include a contact electrode layer disposed on the n-type semiconductor layer, and the contact electrode layer may electrically contact the first pixel electrode.

The opening may be disposed more adjacent to the first electrode than to the second electrode in a plan view.

A thickness of the first insulating layer in a cross-sectional view may be in a range of about 40% to about 75% of a length of the light emitting element.

A width of the opening in a plan view may be in a range of about 40% to about 75% of a length of the light emitting element.

A plurality of openings may be formed in the first insulating layer and arranged in an extending direction of the first pixel electrode. A distance between adjacent ones of the plurality of openings may be in a range of about 40% to about 75% of a length of the light emitting element.

A distance between the first electrode and the second electrode may be in a range of about 80% to about 120% of a length of the light emitting element.

The second insulating layer may be filled in the opening of the first insulating layer.

The display device may further include a third insulating layer disposed between the first and second electrodes and the second insulating layer.

The display device may further include a bank disposed between the first and second electrodes and the second insulating layer, the bank defining an emission area in a plan view.

The display device may further include color conversion particles disposed on the second pixel electrode, the color conversion particles converting a wavelength band of light emitted from the light emitting element.

The display device may further include a color filter disposed on the color conversion particles.

The first pixel electrode may include a first sub-pixel electrode and a second sub-pixel electrode, spaced apart from each other with the second electrode disposed between the first sub-pixel electrode and the second sub-pixel electrode in a plan view and electrically connected with each other. The first electrode may include a first sub-electrode spaced apart from the second electrode with the first sub-pixel electrode disposed between the first sub-electrode and the second electrode in a plan view and a second sub-electrode spaced apart from the second electrode with the second sub-pixel electrode disposed between the second sub-electrode and the second electrode.

In accordance with another aspect of the disclosure, a method of manufacturing a display device may include forming a first pixel electrode on a base layer, forming, on the base layer, a first insulating layer including an opening exposing the first pixel electrode, forming, on the first insulating layer, a first electrode and a second electrode spaced apart from each other with the opening disposed between the first electrode and the second electrode, supplying a light emitting element onto the base layer, aligning the light emitting element between the first electrode and the second electrode by primarily applying a first alignment signal to the first electrode and the second electrode, locating the light emitting element in the opening of the first insulating layer by secondarily applying a second alignment signal to the first pixel electrode and the second electrode, and forming a second pixel electrode on the light emitting element.

The method may further include forming a second insulating layer in the opening of the first insulating layer before the forming of the second pixel electrode, the second insulating layer exposing an end portion of the light emitting element. The second pixel electrode may be disposed on the second insulating layer.

The method may further include forming a third insulating layer covering the first electrode and the second electrode, before the forming of the second insulating layer. The second insulating layer may cover the third insulating layer.

The method may further include forming a bank on the first insulating layer, before the forming of the second insulating layer. The bank may define an emission area in a plan view.

The method may further include forming, on the second pixel electrode, color conversion particles converting a wavelength band of light emitted from the light emitting element, and forming a color filter on the color conversion particles.

### BRIEF DESCRIPTION OF THE DRAWINGS

Embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey the scope of the example embodiments to those skilled in the art.
FIG. 1 is a perspective view illustrating a light emitting element.
FIG. 2A is a schematic cross-sectional view of the light emitting element in FIG. 1.
FIG. 2B is a schematic cross-sectional view of the light emitting element in FIG. 1.
FIG. 3 is a plan view of a display device.
FIG. 4A is a schematic diagram of an equivalent circuit of a sub-pixel included in the display device in FIG. 3.
FIG. 4B is a schematic diagram of an equivalent circuit of a sub-pixel included in the display device in FIG. 3.
FIG. 5A is a plan view of the sub-pixel included in the display device in FIG. 3.
FIG. 5B is a plan view of the sub-pixel included in the display device in FIG. 3.
FIG. 5C is a plan view of the sub-pixel included in the display device in FIG. 3.
FIG. 6 is a schematic cross-sectional view of the sub-pixel taken along line I-I' in FIG. 5B.
FIG. 7A is a schematic cross-sectional view of the sub-pixel taken along line II-II' in FIG. 5B.
FIG. 7B is a schematic cross-sectional view of the sub-pixel taken along line II-II' in FIG. 5B.
FIG. 7C is a schematic cross-sectional view of the sub-pixel taken along line II-II' in FIG. 5B.
FIG. 7D is a schematic cross-sectional view of the sub-pixel taken along line II-II' in FIG. 5B.
FIGS. 8A to 8E are views schematically illustrating a process of manufacturing the display device in FIG. 3.
FIG. 9A is a plan view of the sub-pixel included in the display device in FIG. 3.
FIG. 9B is a plan view of the sub-pixel included in the display device in FIG. 3.
FIG. 10 is a plan view of the sub-pixel included in the display device in FIG. 3.

### DETAILED DESCRIPTION OF THE EMBODIMENTS

The effects and characteristics of the disclosure and a method of achieving the effects and characteristics will be clear by referring to the embodiments described below in detail together with the accompanying drawings. However, the disclosure is not limited to the embodiments disclosed herein but may be implemented in various forms.

The disclosure may apply various changes and different shape, therefore only illustrate in detail with particular embodiments. However, the embodiments do not limit to certain shapes but apply to all the change and equivalent material and replacement. The drawings included are illustrated a fashion where the figures are expanded for the better understanding.

In the drawing figures, dimensions may be exaggerated for clarity of illustration. It will be understood that when an element is referred to as being "between" two elements, it can be the only element between the two elements, or one or more intervening elements may also be present. Like reference numerals refer to like elements throughout.

It will be understood that, although the terms "first," "second," etc. may be used herein to describe various elements, these elements should not be limited by these terms. These terms are only used to distinguish one element from another element. Thus, a "first" element discussed below could also be termed a "second" element without departing from the teachings of the disclosure. As used herein, the singular forms are intended to include the plural forms as well, unless the context clearly indicates otherwise.

It will be further understood that the terms "includes" and/or "including," when used in this specification, specify the presence of stated features, integers, steps, operations, elements, and/or components, but do not preclude the presence and/or addition of one or more other features, integers, steps, operations, elements, components, and/or groups thereof.

Spatially relative terms, such as "beneath", "below", "under", "lower", "above", "upper", "over", "higher", "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below", for example, can encompass both an orientation of above and below. Furthermore, the apparatus may be otherwise oriented (e.g., rotated 90 degrees or at other orientations), and, as such, the spatially relative descriptors used herein interpreted accordingly. Further, an expression that an element such as a layer, region, substrate or plate is placed "on" or "above" another element indicates not only a case where the element is placed "directly on" or "just above" the other element but also a case where a further element is interposed between the element and the other element. Also, an expression that an element such as a layer, region, substrate or plate is placed "beneath" or "below" another element indicates not only a case where the element is placed "directly beneath" or "just below" the other element but also a case where a further element is interposed between the element and the other element.

When an element, such as a layer, is referred to as being "on", "connected to", or "coupled to" another element or layer, it may be directly on, connected to, or coupled to the other element or layer or intervening elements or layers may be present. When, however, an element or layer is referred to as being "directly on", "directly connected to", or "directly coupled to" another element or layer, there are no intervening elements or layers present. To this end, the term "connected" may refer to physical, electrical, and/or fluid connection, with or without intervening elements. Also, when an element is referred to as being "in contact" or "contacted" or the like to another element, the element may be in "electrical contact" or in "physical contact" with another element; or in "indirect contact" or in "direct contact" with another element.

In the specification and the claims, the phrase "at least one of' is intended to include the meaning of "at least one selected from the group of' for the purpose of its meaning and interpretation. For example, "at least one of A and B" may be understood to mean "A, B, or A and B". In the specification and the claims, the term "and/or" is intended to include any combination of the terms "and" and "or" for the purpose of its meaning and interpretation. For example, "A and/or B" may be understood to mean "A, B, or A and B". The terms "and" and "or" may be used in the conjunctive or disjunctive sense and may be understood to be equivalent to "and/or".

The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 30%, 20%, 10%, 5% of the stated value.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated.

Unless otherwise defined or implied herein, all terms (including technical and scientific terms) used have the same meaning as commonly understood by those skilled in the art to which this disclosure pertains. It will be further understood that terms, such as those defined in commonly used dictionaries, should be interpreted as having a meaning that is consistent with their meaning in the context of the relevant art and should not be interpreted in an ideal or excessively formal sense unless clearly defined in the specification.

Hereinafter, a display device in accordance with an embodiment of the disclosure will be described with reference to the accompanying drawings.

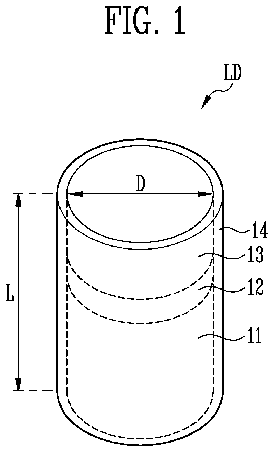

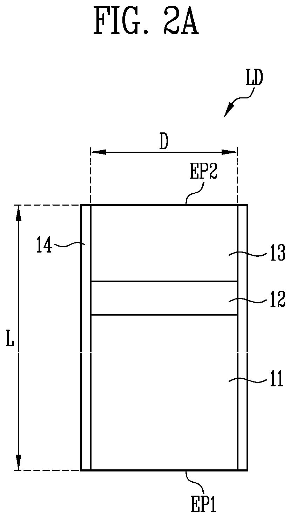

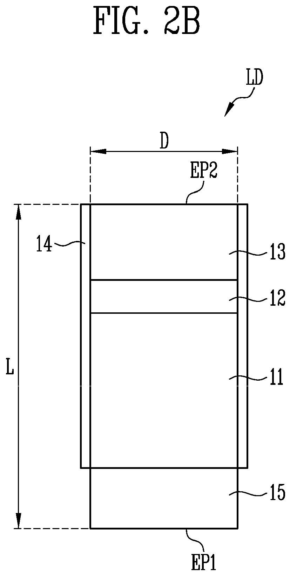

FIG. 1 is a perspective view illustrating a light emitting element. FIGS. 2A and 2B are schematic cross-sectional views of the light emitting element in FIG. 1. Although a pillar-shaped light emitting element LD is illustrated in FIGS. 1, 2A, and 2B, the kind and/or shape of the light emitting element LD is not limited thereto.

Referring to FIGS. 1, 2A, and 2B, the light emitting element LD may include a first semiconductor layer 11, an active layer 12, and a second semiconductor layer 13. In case that an extending direction of the light emitting element LD is a length L direction, the first semiconductor layer 11, the active layer 12, and the second semiconductor layer 13 may be sequentially stacked along the length L direction.

The light emitting element LD may be provided in a pillar shape extending in one direction. The light emitting element LD may have a first end portion EP₁ and a second end portion EP₂. One of the first and second semiconductor layers 11 and 13 may be disposed at the first end portion EP₁ of the light emitting element LD. Another one of the first and second semiconductor layers 11 and 13 may be disposed at the second end portion EP₂ of the light emitting element LD.

The light emitting element LD may be a light emitting element manufactured in a pillar shape through an etching process, or the like. In this specification, the term "pillar shape" may include a rod-like shape or bar-like shape, which is long in the length L direction (i.e., its aspect ratio is greater than 1), such as a cylinder or a polyprism, but the shape of its section is not particularly limited. For example, a length L of the light emitting element LD may be greater than a diameter D (or a width of a cross-section) of the light emitting element LD.

The light emitting element LD may have a size of nanometer scale to micrometer scale. For example, the light emitting element LD may have a diameter D (or width) in a range of nanometer scale to micrometer scale and/or a length L in a range of nanometer scale to micrometer scale. However, the size of the light emitting element LD is not limited thereto, and the size of the light emitting element LD may be variously changed according to design conditions of various types of devices, e.g., a display device, and the like, which use, as a light source, a light emitting device using the light emitting element LD.

The first semiconductor layer 11 may be a first conductivity type semiconductor layer. For example, the first semiconductor layer 11 may include an n-type semiconductor layer. For example, the first semiconductor layer 11 may be an n-type semiconductor layer including at least one semiconductor material such as InAlGaN, GaN, AlGaN, InGaN, AlN, and InN doped with a first conductivity type dopant such as Si, Ge, or Sn. However, the material constituting the first semiconductor layer 11 is not limited thereto. The first semiconductor layer 11 may be configured with various materials.

The active layer 12 may be formed on the first semiconductor layer 11, and may be formed in a single-quantum well structure or a multi-quantum well structure. The active layer 12 may include GaN, InGaN, InAlGaN, AlGaN, A1N, or the like. The active layer 12 may be configured with various materials. A clad layer (not shown) doped with a conductive dopant may be formed on the top and/or the bottom of the active layer 12. For example, the clad layer may be formed as an AlGaN layer or InAlGaN layer.

The second semiconductor layer 13 may be formed on the active layer 12, and may include a semiconductor layer having a type different from that of the first semiconductor layer 11. For example, the second semiconductor layer 13 may include a p-type semiconductor layer. For example, the second semiconductor layer 13 may be a p-type semiconductor layer including at least one semiconductor material such as InAlGaN, GaN, AlGaN, InGaN, A1N, and InN doped with a second conductivity type dopant such as Mg. However, the material constituting the second semiconductor layer 13 is not limited thereto. The second semiconductor layer 13 may be configured with various materials.

In case that a voltage which is a threshold voltage or more is applied to both ends of the light emitting element LD, the light emitting element LD may emit light as electron-hole pairs are recombined in the active layer 12. The light emission of the light emitting element LD may be controlled by using such principle, so that the light emitting element LD may be used as a light source for various light emitting devices, including a pixel of a display device.

The light emitting element LD may further include an insulative (insulating) film 14 provided on a surface thereof. The insulative film 14 may be formed on the surface of the light emitting element LD to surround an outer circumferential surface of at least the active layer 12. The insulative film 14 may further surround an area of each of the first and second semiconductor layers 11 and 13.

The insulative film 14 may expose both the end portions of the light emitting element LD, which have different polarities. For example, the insulative film 14 may expose an end of each of the first and second semiconductor layers 11 and 13 located at the first and second end portions EP₁ and EP₂ of the light emitting element LD. In another implementation, the insulative film 14 may expose a side portion of each of the first and second semiconductor layers 11 and 13 adjacent to the first and second end portions EP₁ and EP₂ of the light emitting element LD, which have different polarities.

The insulative film 14 may be configured as a single layer or a multi-layer (e.g., a double layer configured with aluminum oxide (AlOₓ) and silicon oxide (SiOₓ)), including at least one insulating material such as silicon oxide (SiOₓ), silicon nitride (SiNₓ), silicon oxynitride (SiOₓN_{y}), aluminum oxide (AlOₓ), and titanium oxide (TiOₓ), but the disclosure is not limited thereto. For example, the insulative film 14 may be omitted.

In case that the insulative film 14 is provided to cover the surface of the light emitting element LD, for example, the outer circumferential surface of the active layer 12, the active layer 12 may be prevented from being short-circuited with a first pixel electrode, a second pixel electrode, or the like, which will be described later. Accordingly, the electrical stability of the light emitting element LD may be ensured.

Also, in case that the insulative film 14 is provided on the surface of the light emitting element LD, a surface defect of the light emitting element LD may be minimized, thereby improving the lifetime and light emission efficiency of the light emitting element LD. Even in case that multiple light emitting elements LD are densely disposed, an unwanted short circuit may be prevented from occurring between the light emitting elements LD.

The light emitting element LD may include an additional component in addition to the first semiconductor layer 11, the active layer 12, the second semiconductor layer 13, and/or the insulative film 14 surrounding the same. For example, the light emitting element LD may include at least one phosphor layer, at least one active layer, at least one semiconductor layer, and/or at least one electrode layer, which are disposed at one ends of the first semiconductor layer 11, the active layer 12, and/or the second semiconductor layer 13.

For example, as shown in FIG. 2B, a contact electrode layer 15 may be disposed at the first end portion EP1 of the light emitting element LD. The contact electrode layer 15 may include a conductive oxide such as indium tin oxide (ITO), indium zinc oxide (IZO), zinc oxide (ZnO), indium gallium zinc oxide (IGZO), or indium tin zinc oxide (ITZO), a conductive polymer such as poly(3,4-ethylenedioxythiophene (PEDOT), and the like, but the disclosure is not limited thereto. The contact electrode layer 15 may be completely exposed by the insulative film 14. However, the disclosure is not limited thereto, and the insulative film 14 may surround at least a portion of an outer circumferential surface except an end of the contact electrode layer 15. In some implementations, the contact electrode layer 15 may be also disposed at the second end portion EP2 of the light emitting element LD.

Although the pillar-shaped light emitting element LD has been illustrated in FIGS. 1, 2A, and 2B, the kind, structure, and/or shape of the light emitting element LD may be variously changed. For example, the light emitting element LD may be formed in a core-shell structure having a polypyramid shape.

A light emitting device including the above-described light emitting element LD may be used in various kinds of devices which require a light source, including a display device. For example, multiple light emitting elements LD may be disposed in each pixel of a display panel, and be used as a light source of each pixel. However, the application field of the light emitting element LD is not limited to the above-described example. For example, the light emitting element LD may be used in other types of devices that require a light source, such as a lighting device.

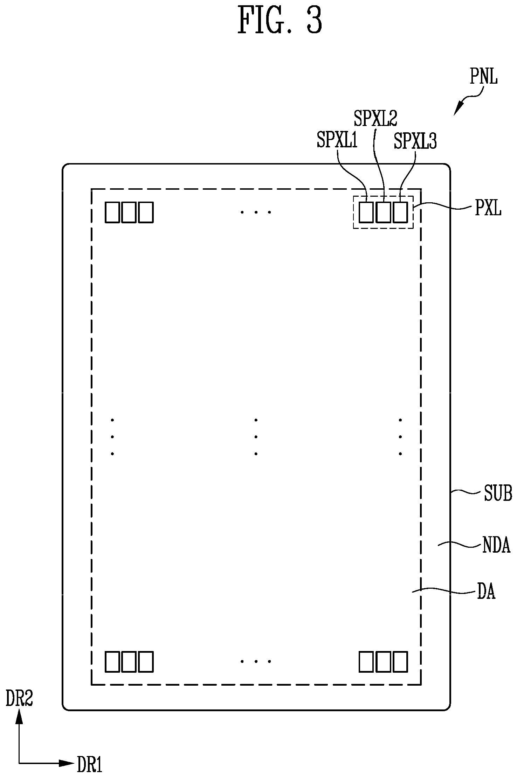

FIG. 3 is a plan view of a display device. In FIG. 3, a display device, particularly, a display panel PNL provided in the display device will be illustrated as an example of an electronic device which uses, as a light source, the light emitting element LD described in the example shown in FIGS. 1, 2A, and 2B.

For convenience of description, in FIG. 3, a structure of the display panel PNL will be briefly illustrated based on a display area DA. In some implementations, at least one driving circuit (e.g., at least one of a scan driver and a data driver), lines, and/or pads may be also disposed in the display panel PNL.

The disclosure may be applied as long as the display device is an electronic device in which a display surface is applied to at least one surface thereof, such as a smartphone, a television, a tablet personal computer (PC), a mobile phone, a video phone, an electronic book reader, a desktop PC, a laptop PC, a netbook computer, a workstation, a server, a personal digital assistant (PDA), a portable multimedia player (PMP), an MP3 player, a medical device, a camera, or a wearable device.

Referring to FIG. 3, the display panel PNL may include a substrate SUB and pixels PXL disposed on the substrate SUB.

The substrate SUB (or base layer) may constitute a base member of the display panel PNL, and may be a rigid or flexible substrate or film. For example, the substrate SUB may be configured as a rigid substrate made of glass or tempered glass, a flexible substrate (or thin film) made of plastic or metal, or at least one insulating layer. The material and/or property of the substrate SUB is not particularly limited.

The substrate SUB may be substantially transparent.. The substrate SUB may be translucent or opaque. The substrate SUB may include a reflective material in some implementations.

The display panel PNL and the substrate SUB for forming the same may include the display area DA for displaying an image and a non-display area NDA other than the display area DA.

The pixels PXL may be arranged in the display area DA. Various lines, pads, and/or a built-in circuit, which are connected to the pixels PXL of the display area DA, may be disposed in the non-display are NDA.

The pixel PXL may include sub-pixels SPXL1 to SPXL3. For example, the pixel PXL may include a first sub-pixel SPXL1, a second sub-pixel SPXL2, and a third sub-pixel SPXL3.

Each of the sub-pixels SPXL₁ to SPXL3 may emit light of a color. The sub-pixels SPXL₁ to SPXL₃ may emit lights of different colors. For example, the first sub-pixel SPXL₁ may emit light of a first color, the second sub-pixel SPXL2 may emit light of a second color, and the third sub-pixel SPXL₃ may emit light of a third color. For example, the first sub-pixel SPXL₁ may be a red pixel emitting light of red, the second sub-pixel SPXL₂ may be a green pixel emitting light of green, and the third sub-pixel SPXL3 may be a blue pixel emitting light of blue. However, the disclosure is not limited thereto.

The first sub-pixel SPXL₁, the second sub-pixel SPXL₂, and the third sub-pixel SPXL₃ may have, as light sources, a light emitting element of the first color, a light emitting element of the second color, and a light emitting element of the third color, to emit lights of the first color, the second color, and the third color, respectively. In another implementation, the first sub-pixel SPXL₁, the second sub-pixel SPXL₂, and the third sub-pixel SPXL₃ may have light emitting elements emitting light of the same color and include color conversion layers and/or color filters of different colors, which are disposed above the respective light emitting elements, to respectively emit lights of the first color, the second color, and the third color. However, the color, kind, and/or number of sub-pixels SPXL₁ to SPXL₃ constituting each pixel PXL are not particularly limited. For example, the color of light emitted by each pixel PXL may be variously changed.

The sub-pixels SPXL₁ to SPXL3 may be regularly arranged in a stripe structure, a PENTILE^{™} structure, or the like. For example, the first, second, and third sub-pixels SPXL₁, SPXL₂, and SPXL₃ may be sequentially and repeatedly disposed along a first direction DR1. The first, second, and third sub-pixels SPXL₁, SPXL₂, and SPXL₃ may be repeatedly disposed along a second direction DR2. At least one first sub-pixel SPXL1, at least one second sub-pixel SPXL₂, and at least one third sub-pixel SPXL3, which are disposed adjacent to each other, may constitute one pixel PXL capable of emitting lights of various colors. However, the arrangement and the number of the sub-pixels SPXL₁ to SPXL₃ are not limited thereto, and the sub-pixels SPXL₁ to SPXL₃ may be arranged in the display area DA in various structures and/or various manners.

Each of the sub-pixels SPXL₁ to SPXL₃ may be configured as an active pixel. For example, each of the sub-pixels SPXL₁ to SPXL3 may include at least one light source (e.g., at least one light emitting element) driven by a control signal (e.g., a scan signal and a data signal) and/or a power source (e.g., a first power source and a second power source). However, the kind, structure, and/or driving method of the sub-pixels SPXL1 to SPXL3, which can be applied to the display device, are not particularly limited.

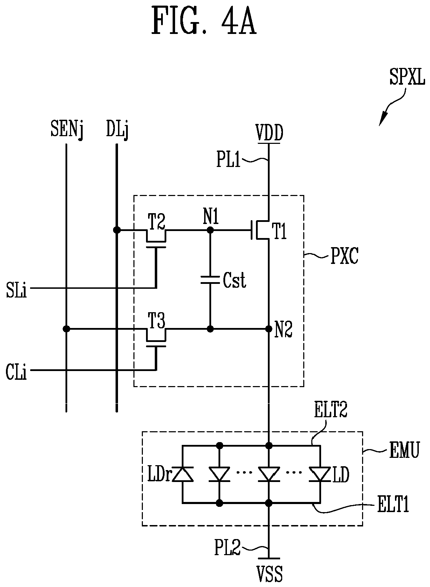

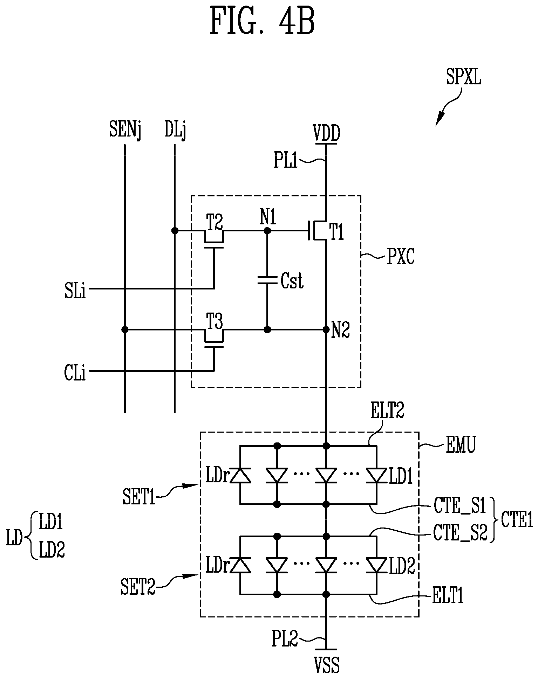

FIGS. 4A and 4B are each schematic diagrams of an equivalent circuit of the sub-pixel included in the display device in FIG. 3.

For example, FIGS. 4A and 4B illustrate an electrical connection relationship of components included in each of sub-pixels SPXL₁ to SPXL₃ applicable to an active matrix type display device. However, the connection relationship of the components of each of the sub-pixels SPXL₁ to SPXL3 is not limited thereto. In the following implementation, in the case that a first sub-pixel SPXL₁, a second sub-pixel SPXL₂, and a third sub-pixel SPXL₃ are inclusively designated, each of the first, second, and third sub-pixels SPXL₁, SPXL₂, and SPXL₃ or the first, second, and third sub-pixels SPXL₁, SPXL₂, and SPXL₃ will be referred to as a "sub-pixel SPXL" or "sub-pixels SPXL."

Referring to FIGS. 3, 4A, and 4B, the sub-pixel SPXL may include a light emitting part EMU (or light emitting unit) which generates light with a luminance corresponding to a data signal. The sub-pixel SPXL may also include a pixel circuit PXC for driving the light emitting part EMU.

The light emitting part EMU may include multiple light emitting elements LD connected in parallel between a first power line PL1 and a second power line PL2. The first power line PL1 may be connected to a first driving power source VDD such that a voltage of the first driving power source VDD is applied thereto, and the second power line PL2 may be connected to a second driving power source VSS such that a voltage of the second driving power source VSS is applied thereto.

For example, the light emitting part EMU may include a second pixel electrode ELT2 (or second electrode) connected to the first driving power source VDD via the pixel circuit PXC and the first power line PL1, a first pixel electrode ELT1 (or first electrode) connected to the second driving power source VSS through the second power line PL2, and multiple light emitting elements LD connected in parallel in the same direction between the second pixel electrode ELT₂ and the first pixel electrode ELT1. The second pixel electrode ELT₂ may be an anode (or anode electrode), and the first pixel electrode ELT₁ may be a cathode (or cathode electrode).

Each of the light emitting elements LD included in the light emitting part EMU may include a first end portion connected to the first driving power source VDD through the second pixel electrode ELT₂ and a second end portion connected to the second driving power source VSS through the first pixel electrode ELT₁. The first driving power source VDD and the second driving power source VSS may have different potentials. For example, the first driving power source VDD may be a high-potential power source, and the second driving power source VSS may be a low-potential power source. A potential difference between the first and second driving power sources VDD and VSS may be equal to or higher than a threshold voltage of the light emitting elements LD during an emission period of the each sub-pixel SPXL.

As described above, the light emitting elements LD connected in parallel in the same direction (e.g., a forward direction) between the second pixel electrode ELT₂ and the first pixel electrode ELT1, to which voltages having difference potentials are supplied, may form respective effective light sources.

Each of the light emitting elements LD of the light emitting part EMU may emit light with a luminance corresponding to a driving current supplied through a corresponding pixel circuit PXC. For example, the pixel circuit PXC may supply, to the light emitting part EMU, a driving current corresponding to a grayscale value of corresponding frame data during each frame period. The driving current supplied to the light emitting part EMU may be divided to flow through each of the light emitting elements LD. Accordingly, the light emitting part EMU may emit light with a luminance corresponding to the driving current as each light emitting element LD emits light with a luminance corresponding to a current flowing therethrough.

Although an implementation in which both end portions of the light emitting elements LD are connected in the same direction between the first and second driving power sources VDD and VSS has been described, the disclosure is not limited thereto. In some implementations, the light emitting part EMU may also include at least one ineffective light source, e.g., a reverse light emitting element LDr, in addition to the light emitting elements LD forming the respective effective light sources. The reverse light emitting element LDr may be connected in parallel together with the light emitting elements LD forming the effective light sources between the first and second pixel electrodes ELT₁ and ELT2, and may be connected between the first and second pixel electrodes ELT₁ and ELT₂ in a direction opposite to the direction in which the light emitting elements LD are connected. Even in the case that a driving voltage (e.g., a forward driving voltage) is applied between the first and second pixel electrodes ELT₁ and ELT₂, the reverse light emitting element LDr may maintain an inactivated state, and accordingly, no current may substantially flow through the reverse light emitting element LDr.

The pixel circuit PXC may be connected to a scan line SLi (or first gate line) and a data line DLj of the sub-pixel SPXL. The pixel circuit PXC may be also connected to a control line CLi (or second gate line) and a sensing line SENj (or readout line) of the sub-pixel SPXL. For example, in case that the sub-pixel SPXL is disposed on an ith row and a jth column of the display area DA, the pixel circuit PXC of the sub-pixel SPXL may be connected to an ith scan line SLi, a jth data line DLj, an ith control line CLi, and a jth sensing line SENj of the display area DA.

The pixel circuit PXC may include transistors T1 to T3 and a storage capacitor Cst.

A first transistor T1 may be a driving transistor for controlling a driving current applied to the light emitting part EMU, and may be connected between the first driving power source VDD and the light emitting part EMU. For example, a first terminal (or a first transistor electrode) of the first transistor T1 may be electrically connected to the first driving power source VDD through the first power line PL1, a second terminal (or second transistor electrode) of the first transistor T1 may be electrically connected to a second node N2, and a gate electrode of the first transistor T1 may be electrically connected to a first node N1. The first transistor T1 may control an amount of driving current applied to the light emitting part EMU through the second node N2 from the first driving power source VDD according to a voltage applied to the first node N1. The first terminal of the first transistor T1 may be a drain electrode, and the second terminal of the first transistor T1 may be a source electrode. However, the disclosure is not limited thereto. Alternatively, the first terminal may be the source electrode, and the second terminal may be the drain electrode.

A second transistor T2 may be a switching transistor which selects a sub-pixel SPXL in response to a scan signal and activates the sub-pixel SPXL, and may be connected between the data line DLj and the first node N1. A first terminal of the second transistor T2 may be connected to the data line DLj, a second terminal of the second transistor T2 may be connected to the first node N1, and a gate electrode of the second transistor T2 may be connected to the scan line SLi. The first terminal and the second terminal of the second transistor T2 may be different terminals. For example, in the case that the first terminal is a drain electrode, the second terminal may be a source electrode.

The second transistor T2 may be turned on in the case that a scan signal having a gate-on voltage (e.g., a high-level voltage) is supplied from the scan line SLi, to electrically connect the data line DLj and the first node N1 to each other. The first node N1 may be a point at which the second terminal of the second transistor T2 and the gate electrode of the first transistor T1 are connected to each other, and the second transistor T2 may transfer a data signal to the gate electrode of the first transistor T1.

A third transistor T3 may connect the first transistor T1 to the sensing line SENj, so that a sensing signal may be acquired through the sensing line SENj. Accordingly, a characteristic of the sub-pixel SPXL, including a threshold voltage of the first transistor T1, and the like, may be detected by using the sensing signal. Information on the characteristic of the sub-pixel SPXL may be used to convert image data such that a characteristic deviation between sub-pixels SPXL may be compensated. A second terminal of the third transistor T3 may be connected to the second terminal of the first transistor T1, a first terminal of the third transistor T3 may be connected to the sensing line SENj, and a gate electrode of the third transistor T3 may be connected to the control line CLi. The first terminal of the third transistor T3 may be also connected to an initialization power source. The third transistor T3 may be an initialization transistor capable of initializing the second node N2, and may be turned on in case that a sensing control signal is supplied from the control line CLi, to transfer the voltage of the initialization power source to the second node N2. Accordingly, a second storage electrode of the storage capacitor Cst, which is electrically connected to the second node N2, may be initialized.

The storage capacitor Cst may include a first storage electrode (or lower electrode) and a second storage electrode (or upper electrode). The first storage electrode may be electrically connected to the first node N1, and the second storage electrode may be electrically connected to the second node N2. The storage capacitor Cst may charge a data voltage corresponding to the data signal supplied to the first node N1 during one frame period. Accordingly, the storage capacitor Cst may store a voltage corresponding to the difference between a voltage of the gate electrode of the first transistor T1 and a voltage of the second node N2.

The light emitting part EMU may include at least one serial stage (or stage) including multiple light emitting elements LD electrically connected in parallel to each other.

The light emitting part EMU may be configured in a series/parallel hybrid structure. For example, as shown in FIG. 4B, the light emitting part EMU may include a first serial stage SET1 and a second serial stage SET2. The number of serial stages included in the light emitting part EMU is not limited and may be variously changed. For example, the light emitting part EMU may include three, four, five or more serial stages. In another implementation, as shown in FIG. 4A, the light emitting part EMU may include only one serial stage.

Referring to FIG. 4B, the light emitting part EMU may include a first serial stage SET₁ and a second serial stage SET2, which are sequentially connected between the first driving power source VDD and the second driving power source VSS. Each of the first serial stage SET₁ and the second serial stage SET2 may include two electrodes ELT2 and CTE_S1 or CTE_S2 and ELT₁ constituting an electrode pair of the corresponding serial stage and multiple light emitting elements LD connected in parallel in the same direction between the two electrodes ELT₂ and CTE_S1 or CTE_S2 and ELT1.

The first serial stage SET₁ (or first stage) may include a second pixel electrode ELT₂ (or first pixel electrode) and a first sub-intermediate electrode CTE_S1, and at least one first light emitting element LD1 connected between the second pixel electrode ELT₂ and the first sub-intermediate electrode CTE_S1. The first serial stage SET₁ may include a reverse light emitting element LDr connected in the opposite direction of the direction in which the first light emitting element LD1 is connected between the second pixel electrode ELT₂ and the first sub-intermediate electrode CTE_S1.

The second serial stage SET2 (or second stage) may include a second sub-intermediate electrode CTE_S2 and a first pixel electrode ELT1 (or second pixel electrode), and at least one second light emitting element LD2 connected between the second sub-intermediate electrode CTE_S2 and the first pixel electrode ELT₁. The second serial stage SET2 may include a reverse light emitting element LDr connected in the opposite direction of the direction in which the second light emitting element LD2 is connected between the second sub-intermediate electrode CTE_S2 and the first pixel electrode ELT₁.

The first sub-intermediate electrode CTE_S1 of the first serial stage SET₁ and the second sub-intermediate electrode CTE_S2 of the second serial stage SET2 may be integral with each other. For example, the first sub-intermediate electrode CTE_S1 and the second sub-intermediate electrode CTE_S2 may constitute a first intermediate electrode CTE1 for electrically connecting the first serial stage SET₁ and the second serial stage SET2, which are consecutive. In case that the first sub-intermediate electrode CTE_S1 and the second sub-intermediate electrode CTE_S2 are integral with each other, the first sub-intermediate electrode CTE_S1 and the second sub-intermediate electrode CTE_S2 may be different areas of the first intermediate electrode CTE1.

As described above, the light emitting part EMU of the sub-pixel SPXL, which includes serial stages SET₁ and SET2 (or light emitting elements LD) connected in a series/parallel hybrid structure, may readily control driving current/voltage conditions to be suitable for specifications of a product to which the light emitting part EMU is applied.

For example, the light emitting part EMU of the sub-pixel SPXL, which includes the serial stages SET₁ and SET2 (or the light emitting elements LD) connected in the series/parallel hybrid structure, may decrease a driving current, as compared with a light emitting part having a structure in which light emitting elements LD are connected only in parallel. Also, the light emitting part EMU of the sub-pixel SPXL, which includes the serial stages SET₁ and SET2 connected in the series/parallel hybrid structure, may decrease a driving voltage applied to both ends of the light emitting part EMU, as compared with a light emitting part having a structure in which the same number of light emitting elements LD are connected only in series.

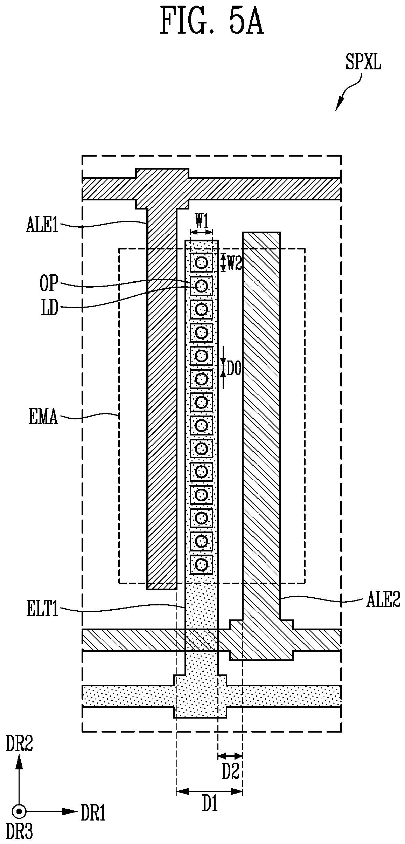

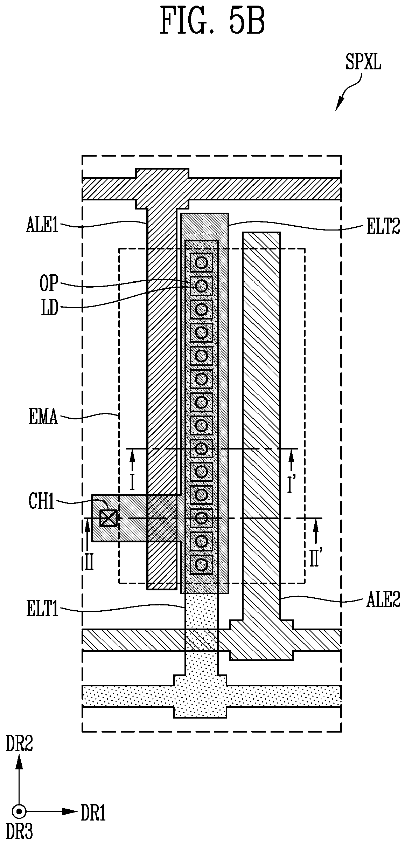

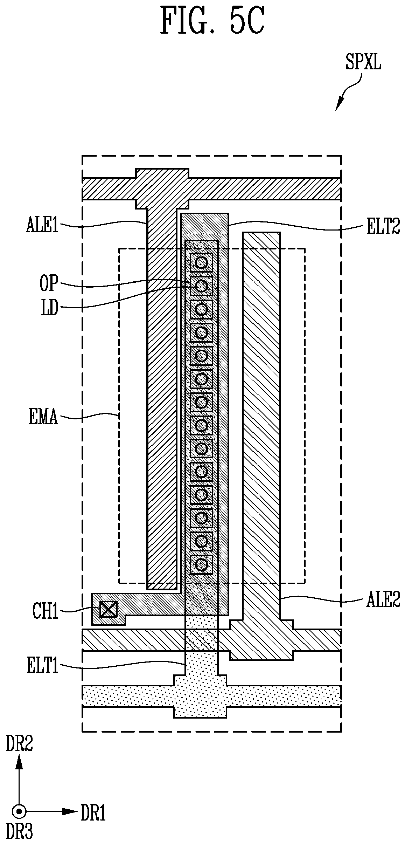

FIGS. 5A, 5B, and 5C are plan views of the sub-pixel included in the display device in FIG. 3. In FIGS. 5A, 5B, and 5C, a sub-pixel SPXL is briefly illustrated based on the light emitting part EMU (see FIG. 4A).

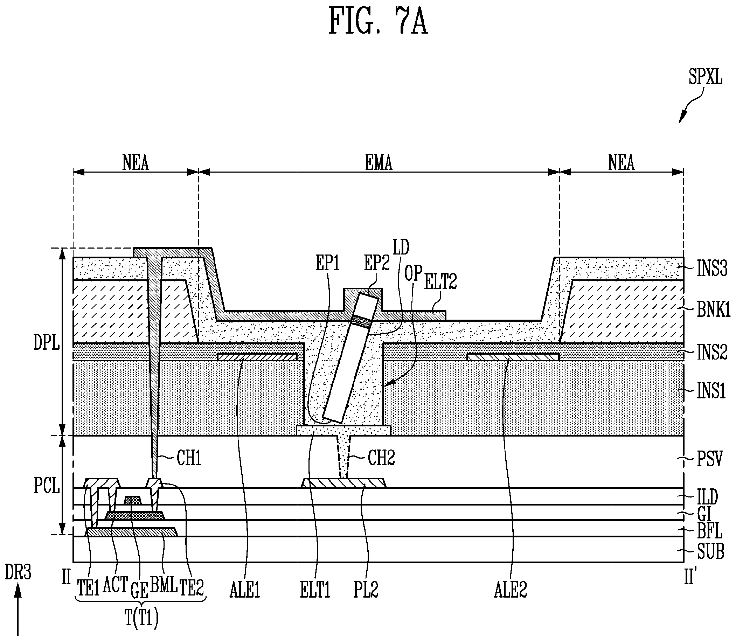

Referring to FIGS. 3, 5A, 5B, and 5C, the sub-pixel SPXL may be formed in a sub-pixel area (or pixel area) provided on the substrate SUB (see FIG. 3). The sub-pixel area (or the sub-pixel SPXL) may include an emission area EMA and a non-emission area other than the emission area EMA. The non-emission area may be an area surrounding the emission area EMA. Although this will be described later with reference to FIG. 7A, the emission area EMA may be defined by a first bank BNK1 (see FIG. 7A), but the disclosure is not limited thereto.

The sub-pixel SPXL may include a first pixel electrode ELT₁, a first electrode ALE1 (or first alignment electrode), a second electrode ALE2 (or second alignment electrode), a second pixel electrode ELT₂, and light emitting elements LD.

Each of the first pixel electrode ELT₁, the first electrode ALE1, the second electrode ALE2, and the second pixel electrode ELT₂ may extend in the second direction DR2 in the emission area EMA.

In some implementations, at least one of the first pixel electrode ELT₁, the first electrode ALE1, and the second electrode ALE2 of the sub-pixel SPXL may extend in the first direction DR1 and be connected to a corresponding electrode of an adjacent sub-pixel. For example, the first pixel electrode ELT₁ may extend in the second direction DR2 in the non-emission area and be connected to a first pixel electrode ELT₁ of an adjacent sub-pixel. In another implementation, the first pixel electrode ELT1 may extend in the first direction DR1 in the non-emission area and be connected to a first pixel electrode ELT1 of an adjacent sub-pixel. Similarly, each of the first electrode ALE1 and the second electrode ALE2 may extend in the second direction DR2 in the non-emission area, and the first electrode ALE1 and the second electrode ALE2 may be electrically connected respectively to a first electrode ALE1 and a second electrode ALE2 of an adjacent sub-pixel.

In a plan view, the first electrode ALE1 and the second electrode ALE2 may be disposed to be spaced apart from each other in the first direction DR1 with the first pixel electrode ELT₁ interposed therebetween. The second pixel electrode ELT₂ may be disposed to overlap the first pixel electrode ELT1 in the third direction DR3. The second pixel electrode ELT₂ may not overlap the first electrode ALE1 and the second electrode ALE2, or may overlap at least one of the first electrode ALE1 and the second electrode ALE2. For example, as shown in FIG. 5B, the second pixel electrode ELT₂ may overlap the first electrode ALE1. In another example, as shown in FIG. 5C, the second pixel electrode ELT₂ may not overlap the first electrode ALE1 and the second electrode ALE2.

A first distance D1 (or shortest distance) between the first electrode ALE1 and the second electrode ALE2 may be about 80% to about 120% of the length L (see FIG. 1) of the light emitting element LD. For example, in case that the length L (see FIG. 1) of the light emitting element LD is in a range of about 3.5µm to about 4.5 µm, the first distance D1 between the first electrode ALE1 and the second electrode ALE2 may be about 4 µm. In the case that the first distance D1 between the first electrode ALE1 and the second electrode ALE2 is smaller than about 80% of the length L of the light emitting element LD, the light emitting element LD may not be disposed in an opening OP in a desired direction, and the light emitting element LD may be primarily disposed in an oblique direction in a plan view. In the case that the first distance D1 between the first electrode ALE1 and the second electrode ALE2 is greater than about 120% of the length L of the light emitting element LD, the light emitting element LD may not be disposed in an opening OP in a desired direction, and a deviation may occur at the position of an end portion of the light emitting element LD.

The first pixel electrode ELT₁ may be disposed adjacent to one of the first electrode ALE1 and the second electrode ALE2.

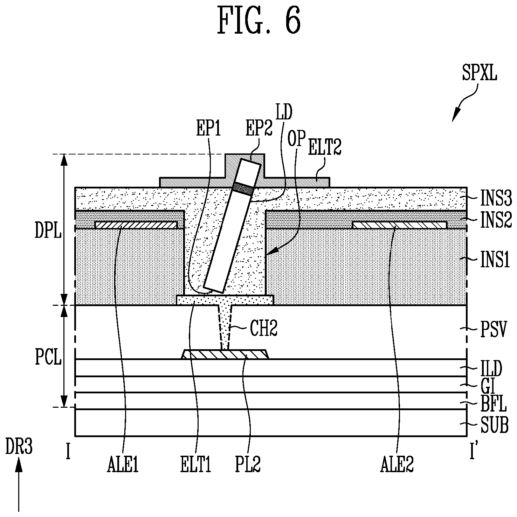

The second electrode ALE2 may be spaced further apart from the first pixel electrode ELT₁ than the first electrode ALE1. The second electrode ALE2 may be spaced apart by about 40% to about 75% of the length L (see FIG. 1) of the light emitting element LD or about 50% of the length L (see FIG. 1) of the light emitting element LD from the first pixel electrode ELT₁ in the first direction DR₁. For example, in case that the length L (see FIG. 1) of the light emitting element LD is in a range of about 3.5 µm to about 4.5 µm, a second distance D2 (or shortest distance) between the second electrode ALE2 and the first pixel electrode ELT₁ (or a side of the first pixel electrode ELT₁, which faces the second electrode ALE2) may be in a range of about 2 µm to about 3 µm. In a plan view, the first electrode ALE1 may be spaced apart from the first pixel electrode ELT₁, but the disclosure is not limited thereto. For example, in a plan view, the first electrode ALE1 may partially overlap the first pixel electrode ELT1 in the third direction DR3. The arrangement of the first electrode ALE1, the second electrode ALE2, and the first pixel electrode ELT₁ and the effect caused thereby will be described later with reference to FIG. 6.

In a plan view, the first pixel electrode ELT₁, the first electrode ALE1, the second electrode ALE2, and the second pixel electrode ELT₂ may have a bar-like shape extending in the second direction DR2, but the disclosure is not limited thereto. The first pixel electrode ELT1, the first electrode ALE1, and the second electrode ALE2 may have various planar shapes (e.g., a bent shape and a donut shape) as long as the first electrode ALE1 and the second electrode ALE2 are disposed to be spaced apart from each other with the first pixel electrode ELT₁ interposed therebetween. Also, the second pixel electrode ELT₂ may have various planar shapes as long as the second pixel electrode ELT₂ overlaps the first pixel electrode ELT₁ in the third direction DR3 or is electrically stably connected to the light emitting elements LD.

After a mixed solution (e.g., an ink) including the light emitting element LD is input to the emission area EMA, a primary alignment voltage may be applied to the first electrode ALE1 and the second electrode ALE2, so that the first electrode ALE1 and the second electrode ALE2 are used as primary alignment electrodes. The first electrode ALE1 may become a first alignment electrode, and the second electrode ALE2 may become a second alignment electrode. Similarly, a secondary alignment voltage may be applied to the first pixel electrode ELT₁ and the second electrode ALE2, so that the first pixel electrode ELT₁ and the second electrode ALE2 are used as secondary alignment electrodes. The first pixel electrode ELT1 may become a third alignment electrode. The light emitting element LD may be aligned in a horizontal direction (or the first direction DR1) between the first alignment electrode and the second alignment electrode by an electric field primarily formed between the first alignment electrode and the second alignment electrode. The light emitting element LD may be vertically aligned on the first pixel electrode ELT₁ by an electric field secondarily formed between the third alignment electrode and the second electrode ALE2. For example, the light emitting element LD may be aligned in a desired direction and/or at a desired position.

After the light emitting elements LD are aligned, the first pixel electrode ELT₁ may be used as a driving electrode for driving the light emitting elements LD. For example, the first pixel electrode ELT₁ may constitute a cathode of the light emitting part EMU (see FIG. 4A). The first pixel electrode ELT₁ may be connected to the second power line PL2 shown in FIG. 4A through a second contact hole CH2 (see FIG. 6) or the like. The second pixel electrode ELT₂ may constitute an anode of the light emitting part EMU. Similarly to the first pixel electrode ELT₁, the second pixel electrode ELT₂ may be connected to the first transistor T1 shown in FIG. 4A through a first contact hole CH1 (see FIG. 7A). The first pixel electrode ELT₁ and the second pixel electrode ELT₂ may be electrically separated from the first electrode ALE1 and the second electrode ALE2, and the first electrode ALE1 and the second electrode ALE2 may be electrically separated from each other. For example, while the display device is driven, the first electrode ALE1 and the second electrode ALE2 may be in a floating state (e.g., a state in which the first electrode ALE1 and the second electrode ALE2 are not connected to any other component), but the disclosure is not limited thereto.

The light emitting elements LD may be disposed between the first pixel electrode ELT₁ and the second pixel electrode ELT₂ such that the length L (see FIG. 1) of each of the light emitting elements LD is generally parallel to a third direction DR3. For example, the light emitting elements LD may be vertically aligned between the first pixel electrode ELT₁ and the second pixel electrode ELT2.

A first insulating layer INS1 (see FIG. 6) covering the first pixel electrode ELT₁ may be disposed. The first insulating layer INS1 may include an opening OP exposing the first pixel electrode ELT₁, and the light emitting element LD may be disposed in the opening OP of the first insulating layer INS1. The openings OP may be arranged in an extending direction of the first pixel electrode ELT₁. Similar to the first pixel electrode ELT1, the opening OP of the first insulating layer may be disposed more adjacent (closer) to the first electrode ALE1 than to the second electrode ALE2 in a plan view.

A first width W1 of the opening OP in the first direction DR1 may be in a range of about 40% to about 75% or about 50% of the length L (see FIG. 1) of the light emitting element LD. For example, in case that the length L (see FIG. 1) of the light emitting element LD is in a range of about 3.5 µm to about 4.5 µm, the first width W1 of the opening OP in the first direction DR1 may be in a range of about 2 µm to about 3 µm. A second width W2 of the opening OP in the second direction DR2 may be equal or similar to the first width W1. For example, the second width W2 of the opening OP in the second direction DR2 may be in a range of about 2 µm to about 3 µm. In the case that the first and second widths W1 and W2 (or diameters) of the opening OP are greater than about 75% of the length L of the light emitting element LD, the light emitting element LD may be aligned in the horizontal direction in the opening OP. In case that the first and second widths W1 and W2 (or diameters) of the opening OP are smaller than about 40% of the length L of the light emitting element LD, the light emitting element LD may not be disposed in the opening OP. For example, the first and second widths W1 and W2 (or diameters) of the opening OP are in a range of about 40% to about 75% or about 50% of the length L of the light emitting element LD, the light emitting element LD may be aligned in a vertical direction (i.e., the third direction DR3) in the opening OP.

A distance Do between the opening OP and an adjacent opening in the second direction DR2 may be in a range of about 40% to about 75% or about 50% of the length L (see FIG. 1) of the light emitting element LD. For example, the distance Do may be in a range of about 2 µm to about 3 µm. However, the distance Do is not limited thereto. The distance Do may be smaller than about 2 µm according to a mask for forming the opening OP.

Although the case where the opening OP has a quadrangular planar shape is illustrated in FIGS. 5A, 5B, and 5C, the disclosure is not limited thereto. The opening OP may have a planar shape such as a circular shape, an elliptical shape, and a polygonal shape excluding a quadrangle.

Also, although the case where one light emitting element LD is disposed in one opening OP is illustrated in FIGS. 5A, 5B, and 5C, the disclosure is not limited thereto. Multiple light emitting elements LD may be disposed in one opening OP according to the size of the opening OP and the diameter D (see FIG. 1) of the light emitting element LD.

FIG. 6 is a schematic cross-sectional view of the sub-pixel taken along line I-I' in FIG. 5B.

In FIG. 6, a sub-pixel SPXL is simplified and illustrated such as that each electrode is illustrated only as a single-film electrode and that each insulating layer is illustrated only as a single-film insulating layer. However, the disclosure is not limited thereto.

Referring to FIGS. 5A, 5B, and 6, the sub-pixel SPXL may include a pixel circuit layer PCL and a display element layer DPL, which are disposed on a substrate SUB (or base layer).

The pixel circuit layer PCL may include a second power line PL2. The second power line PL2 may constitute the second power line PL2 described with reference to FIG. 4A. The pixel circuit layer PCL may also include multiple insulating layers BFL, GI, ILD, and PSV. The insulating layers BFL, GI, ILD, and PSV may include a buffer layer BFL, a gate insulating layer GI, an interlayer insulating layer ILD, and a protective layer PSV, which are sequentially stacked on the substrate SUB. The insulating layers BFL, GI, ILD, and PSV will be described later together with a transistor T shown in FIG. 7A.

The display element layer DPL may be disposed on the protective layer PSV. The display element layer DPL may include a first pixel electrode ELT₁, a first insulating layer INS1 (or first organic layer), a first electrode ALE1, a second electrode ALE2, a second insulating layer INS2 (or inorganic layer), a light emitting element LD, a third insulating layer INS3 (or second organic layer), and a second pixel electrode ELT2.

The first pixel electrode ELT₁ may be disposed on the protective layer PSV.

The first pixel electrode ELT₁ may include at least one conductive material. For example, the first pixel electrode ELT₁ may include at least one metal or one alloy including the same among various metallic materials including silver (Ag), magnesium (Mg), aluminum (Al), platinum (Pt), palladium (Pd), gold (Au), nickel (Ni), neodymium (Nd), iridium (Ir), chromium (Cr), titanium (Ti), molybdenum (Mo), copper (Cu), and the like, or include at least one conductive oxide such as Indium Tin Oxide (ITO), Indium Zinc Oxide (IZO), Indium Tin Zinc Oxide (ITZO), Zinc Oxide (ZnO), Aluminum doped Zinc Oxide (AZO), Gallium doped Zinc Oxide (GZO), Zinc Tin Oxide (ZTO), Gallium Tin Oxide (GTO), and Fluorine doped Tin Oxide (FTO), or a conductive polymer such as PEDOT. However, the disclosure is not necessarily limited thereto. The first pixel electrode ELT₁ may be a reflective member, and may guide light emitted from a first end portion EP1 of the light emitting element LD to a front direction of the sub-pixel SPXL, i.e., the third direction DR3.

The first insulating layer INS1 may be disposed over the first pixel electrode ELT₁. An opening OP exposing the first pixel electrode ELT₁ may be formed in the first insulating layer INS1. The first insulating layer INS1 and the opening OP may form a step such that the light emitting element LD can be vertically aligned. A thickness of the first insulating layer INS1 in the third direction DR3 may be in a range of about 40% to about 75% or about 50% of the length L (see FIG. 1) of the light emitting element LD. For example, in case that the length L (see FIG. 1) of the light emitting element LD is in a range of about 3.5 µm to about 4.5 µm, the thickness of the first insulating layer INS1 may be in a range of about 2 µm to about 3 µm.

The opening OP may have a quadrangular shape in a cross-sectional view, but the disclosure is not limited thereto. For example, the opening OP may be formed such that the first insulating layer INS1 has an inclined surface inclined at an angle with reference to the substrate SUB.

The first insulating layer INS1 may include an organic material. For example, the first insulating layer INS1 may include an organic material such as an acrylic resin, an epoxy resin, a phenolic resin, a polyamide resin, a polyimide resin, a polyester resin, a poly-phenylene sulfide resin, or benzocyclobutene (BCB) resin. However, the first insulating layer INS1 is not limited thereto, and the first insulating layer INS1 may include an inorganic material. For example, the first insulating layer INS1 may include silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), titanium oxide (TiOₓ), or the like, but the disclosure is not limited thereto.

The first electrode ALE1 and the second electrode ALE2 may be disposed on the first insulating layer INS1. The first electrode ALE1 and the second electrode ALE2 may be formed in the same layer. For example, the first electrode ALE1 and the second electrode ALE2 may be simultaneously formed through the same process. Each of the first electrode ALE1 and the second electrode ALE2 may include at least one conductive material.

The second insulating layer INS2 may be disposed over the first electrode ALE1 and the second electrode ALE2. An opening corresponding to the opening OP of the first insulating layer INS1 may be formed in the second insulating layer INS₂. The opening of the second insulating layer INS2 may be formed with the opening OP of the first insulating layer INS1 through the same process (e.g., collective etching) or different processes.

The second insulating layer INS2 may cover the first electrode ALE1 and the second electrode ALE2, and prevent the first electrode ALE1 and the second electrode ALE from being damaged in a manufacturing process. Also, the second insulating layer INS2 may prevent the first electrode ALE1 and the second electrode ALE2 from being in contact with the light emitting element LD (accordingly, being short-circuited). In some implementations, the second insulating layer INS2 may be omitted.

The second insulating layer may include an inorganic material and/or an organic material.

The light emitting element LD may be disposed in the opening OP of the first insulating layer INS1. The light emitting element LD may be vertically disposed in the opening OP of the first insulating layer INS1. The first end portion EP1 of the light emitting element LD may face the opposite direction of the third direction DR3, and a second end portion EP2 of the light emitting element LD may face the third direction DR3. In case that the second end portion EP2 of the light emitting element LD faces in the third direction DR3, light emitted from the active layer 12 (see FIG. 1) of the light emitting element LD, which is more adjacent to the second end portion EP2 than the first end portion EP1, may advance in the third direction DR3. The light emission efficiency of the sub-pixel SPXL may be improved as compared with a horizontally aligned light emitting element (i.e., light is emitted in the first direction DR1 and/or the second direction DR2), and a phenomenon in which the light advances toward an adjacent sub-pixel (color mixture according to the phenomenon) may be prevented. Further, since a separate reflective plate for guiding light emitted from the light emitting element LD in the third direction DR3 (e.g., a component for reflecting light emitted in the first direction DR1 and/or the second direction DR2 from the horizontally aligned light emitting element in the third direction DR3) is not required, a problem caused by the reflective plate (e.g., deterioration of image quality, which is caused by external light reflection) may be reduced or minimized. For example, the light emission efficiency and the image quality can be improved.

The first end portion EP1 of the light emitting element LD may be in contact with the first pixel electrode ELT₁. In case that the first pixel electrode ELT₁ includes indium tin oxide (ITO), indium zinc oxide (IZO), indium tin zinc oxide (ITZO), or the like or in case that the contact electrode layer 15 (see FIG. 2B) is disposed at the first end portion EP1 of the light emitting element LD, the first end portion EP1 of the light emitting element LD may be more stably in contact with the first pixel electrode ELT₁.

The third insulating layer INS3 may be disposed on the second insulating layer INS2. The third insulating layer INS3 may fill the opening OP of the first insulating layer INS1, and surround the light emitting element LD. The third insulating layer INS3 may expose the second end portion EP2 of the light emitting element LD. The third insulating layer INS3 may reduce a step difference occurring due to components on the bottom thereof, and have a flat surface. For example, the third insulating layer INS3 may include an organic material, but the disclosure is not limited thereto.

The second pixel electrode ELT₂ may be disposed over the second end portion EP2 of the light emitting element LD, which is exposed by the third insulating layer INS3.

The second pixel electrode ELT₂ may be disposed directly on the second end portion EP2 of the light emitting element LD, to be in contact with the second end portion EP2 of the light emitting element LD. The second pixel electrode ELT₂ may be electrically connected to a transistor (e.g., the transistor T shown in FIG. 7A) through a contact hole (e.g., the first contact hole CH1 shown in FIG. 7A) penetrating the first, second, and third insulating layers INS1, INS2, and INS3 and the protective layer PSV, or the like.

The second pixel electrode ELT₂ may be configured with various transparent conductive materials. Accordingly, light emitted from the second end portion EP2 of the light emitting element LD may be emitted to the outside in the third direction DR3 while passing through the second pixel electrode ELT2. The second pixel electrode ELT₂ may include a conductive oxide such as Indium Tin Oxide (ITO), Indium Zinc Oxide (IZO), Indium Tin Zinc Oxide (ITZO), Zinc Oxide (ZnO), Aluminum doped Zinc Oxide (AZO), Gallium doped Zinc Oxide (GZO), Zinc Tin Oxide (ZTO), Gallium Tin Oxide (GTO), and Fluorine doped Tin Oxide (FTO), a conductive polymer such as PEDOT, or the like.

An overcoat layer (not shown) may be disposed over the second pixel electrode ELT2. The overcoat layer may be an inorganic layer including an inorganic material and/or an organic layer including an organic material. For example, the overcoat layer may have a structure in which at least one inorganic layer and at least one organic layer are alternately stacked each other. The overcoat layer may entirely cover the display element layer DPL, thereby preventing external moisture, humidity, or the like from being introduced into the display element layer DPL including the light emitting element LD. The overcoat layer may planarize a top surface of the display element layer DPL.

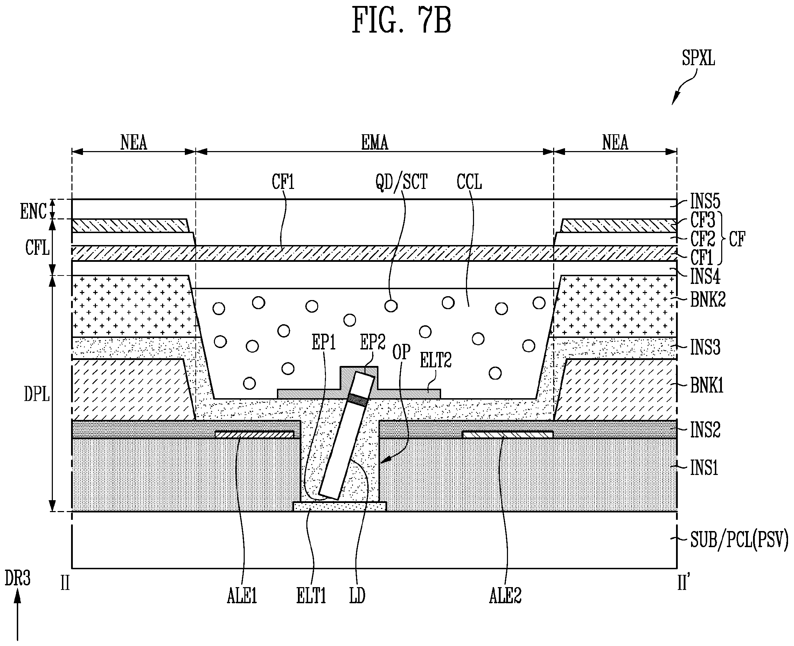

The display element layer DPL may include an optical layer, or an optical layer may be disposed on the display element layer DPL. For example, the display element layer DPL may include a color conversion layer including color conversion particles for converting light emitted from light emitting elements LD into light of a specific color. The display element layer DPL may include a color filter for passing only light in a specific wavelength band. The color conversion layer will be described later with reference to FIGS. 7B to 7D.

As described above, the light emitting element LD may be vertically aligned in the opening OP of the first insulating layer INS1. Accordingly, the light emission efficiency of the sub-pixel SPXL may be improved, and a color mixture phenomenon between adjacent sub-pixels can be prevented.

FIG. 7A is a schematic cross-sectional view of the sub-pixel taken along line II-II' in FIG. 5B.

Referring to FIGS. 5A, 5B, 6, and 7A, the sub-pixel SPXL may include a transistor T and a first bank BNK1. The transistor T may be disposed in the pixel circuit layer PCL, and the first bank BNK1 may be disposed in the display element layer DPL. The transistor T may be any one of the transistors T1 to T3 shown in FIG. 4A. Hereinafter, it is described that the transistor T is the first transistor T1 shown in FIG. 4A.

The first bank BNK1 may be disposed between the second insulating layer INS2 and the third insulating layer INS3. The first bank BNK1 may be located in a non-emission area NEA. For example, the first bank BNK1 may include an opening in the emission area EMA. The first bank BNK1 may be a structure defining (or partitioning) an emission area EMA of each sub-pixel SPXL between the sub-pixels SPXL₁ to SPXL₃ (see FIG. 3). The first bank BNK1 may be a pixel defining layer or a dam structure, which defines an area to which light emitting elements LD are to be supplied in a process of supplying the light emitting elements LD to each of the sub-pixels SPXL1 to SPXL₃. For example, the emission area EMA of the sub-pixel SPXL may be partitioned by the first bank BNK1, so that a desired amount and/or a desired kind of an ink (e.g., a mixed solution including the light emitting elements LD) including a desired amount and/or a desired kind of light emitting element LD can be supplied (or input) to the emission area EMA. The first bank BNK1 may include a liquid repellant.

The first bank BNK1 may include an organic material such as an acrylic resin, an epoxy resin, a phenolic resin, a polyamide resin, a polyimide resin, a polyester resin, a poly-phenylene sulfide resin, or benzocyclobutene (BCB) resin. However, the disclosure is not necessarily limited thereto, and the first bank BNK1 may include various kinds of inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The first transistor T1 may include a lower conductive layer BML, a semiconductor pattern ACT, a gate electrode GE, and first and second transistor electrodes TE1 and TE2. The first transistor T1 may be located in the non-emission area NEA, but the disclosure is not limited thereto. For example, the first transistor T1 may be located in the emission area EMA.

The lower conductive layer BML may be disposed on the substrate SUB. The lower conductive layer BML may overlap the semiconductor pattern ACT of the first transistor T1 in the third direction DR3, and constitute a back-gate electrode of the first transistor T1.

The lower conductive layer BML may be formed as a single layer or a multi-layer, which includes molybdenum (Mo), copper (Cu), aluminum (Al), chromium (Cr), gold (Au), titanium (Ti), nickel (Ni), neodymium (Nd), indium (In), tin (Sn), or oxides or alloys thereof.

The buffer layer BFL may be disposed over the lower conductive layer BML. The buffer layer BFL may prevent an impurity from being diffused into a circuit element. The buffer layer BFL may be configured as a single layer. However, the disclosure is not limited thereto, and the buffer layer BFL may be configured as a multi-layer including at least two layers. In case that the buffer layer BFL is formed as multi-layer, the layers may be formed of the same material or be formed of different materials.

The semiconductor pattern ACT may be disposed on the buffer layer BFL. For example, the semiconductor pattern ACT may include a first region in contact with the first transistor electrode TE1, a second region in contact with the second transistor electrode TE2, and a channel region located between the first region and the second region. One of the first and second regions may be a source region, and another one of the first and second regions may be a drain region.

The semiconductor pattern ACT may be made of poly-silicon, amorphous silicon, an oxide semiconductor, or the like. The channel region of the semiconductor pattern ACT may be a semiconductor pattern undoped with any impurity, and may be an intrinsic semiconductor. Each of the first and second regions of the semiconductor pattern ACT may be a semiconductor doped with an impurity.

The gate insulating layer GI may be disposed on the buffer layer BFL and the semiconductor pattern ACT. For example, the gate insulating layer GI may be disposed between the semiconductor pattern ACT and the gate electrode GE. The gate insulating layer GI may be configured as a single layer or a multi-layer, and include various kinds of inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The gate electrode GE of the first transistor T1 may be disposed on the gate insulating layer GI. The gate electrode GE may overlap the semiconductor pattern ACT in the third direction DR3.

The gate electrode GE may be formed as a single layer or a multi-layer, which includes molybdenum (Mo), copper (Cu), aluminum (Al), chromium (Cr), gold (Au), titanium (Ti), nickel (Ni), neodymium (Nd), indium (In), tin (Sn), and oxides or alloys thereof. For example, the gate electrode GE may be formed as a multi-layer in which titanium (Ti), copper (Cu), and/or indium tin oxide (ITO) are sequentially or repeatedly stacked.

The interlayer insulating layer ILD may be disposed over the gate electrode GE. For example, the interlayer insulating layer ILD may be disposed between the gate electrode GE and the first and second transistor electrodes TE1 and TE2.

The interlayer insulating layer ILD may be configured as a single layer or a multi-layer, and include various kinds of inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The first and second transistor electrodes TE1 and ET2 of the first transistor T1 and the second power line PL2 may be disposed on the interlayer insulating layer ILD. The first and second transistor electrodes TE1 and TE2 and the second power line PL2 may be disposed in the same layer. For example, the first and second transistor electrodes TE1 and TE2 and the second power line PL2 may be simultaneously formed through the same process, but the disclosure is not necessarily limited thereto.

The first and second transistor electrodes TE1 and TE2 may overlap the semiconductor pattern ACT in the third direction DR3. The first and second transistor electrodes TE1 and TE2 may be electrically connected to the semiconductor pattern ACT. For example, the first transistor electrode TE1 may be electrically connected to the first region of the semiconductor pattern ACT through a contact hole penetrating the interlayer insulating layer ILD and the gate insulating layer GI. Also, the first transistor electrode TE1 may be electrically connected to the lower conductive layer BML through a contact hole penetrating the interlayer insulating layer ILD, gate insulating layer GI, and the buffer layer BFL. The second transistor electrode TE2 may be electrically connected to the second region of the semiconductor pattern ACT through a contact hole penetrating the interlayer insulating layer ILD and the gate insulating layer GI. One of the first and second transistor electrodes TE1 and TE2 may be a source electrode, and another one of the first and second transistor electrodes TE1 and TE2 may be a drain electrode.

The first and second transistor electrodes TE1 and TE2 and the second power line PL2 may be formed as a single layer or a multi-layer, which includes molybdenum (Mo), copper (Cu), aluminum (Al), chromium (Cr), gold (Au), titanium (Ti), nickel (Ni), neodymium (Nd), indium (In), tin (Sn), and oxides or alloys thereof.

The protective layer PSV (or via layer) may be disposed over the first and second transistor electrodes TE1 and TE2 and the second power line PL2.

The protective layer PSV may be made of an organic material to planarize a step difference. For example, the protective layer PSV may include an organic material such as an acrylic resin, an epoxy resin, a phenolic resin, a polyamide resin, a polyimide resin, a polyester resin, a poly-phenylene sulfide resin, or benzocyclobutene (BCB) resin. However, the disclosure is not necessarily limited thereto, and the protective layer PSV may include various kinds of inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ). In another implementation, an insulating layer including the inorganic material may be disposed between the protective layer PSV including the organic material and the first and second transistor electrode TE1 and TE2.

The second pixel electrode ELT2 may be electrically connected to the second transistor electrode TE2 of the first transistor T1 through a first contact hole CH1 penetrating the third insulating layer INS3, the first bank BNK1, the second insulating layer INS2, the first insulating layer INS1, and the protective layer PSV. The first contact hole CH1 may be disposed in the non-emission area NEA, but the disclosure is not limited thereto. For example, in the case that the first transistor T1 is located in the emission area EMA, the first contact hole CH1 may be located in the emission area EMA.

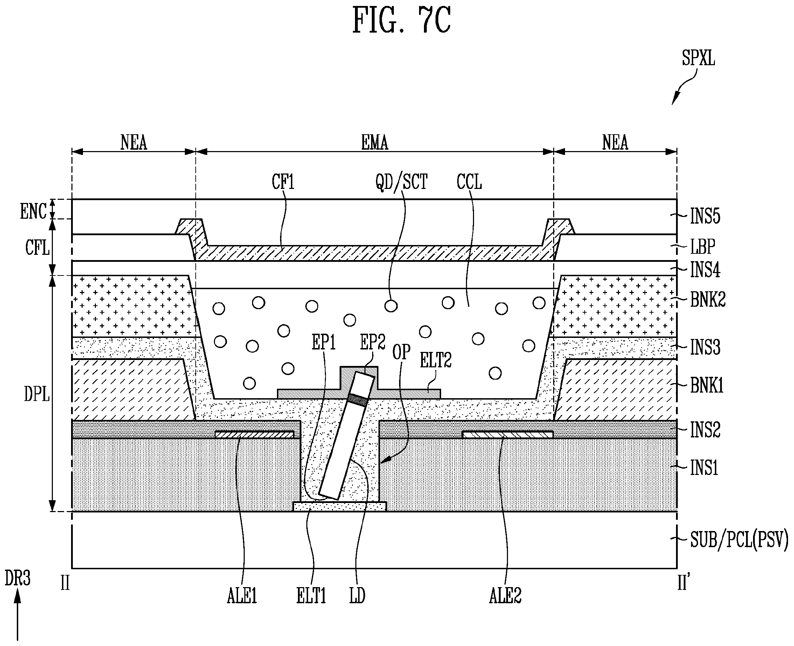

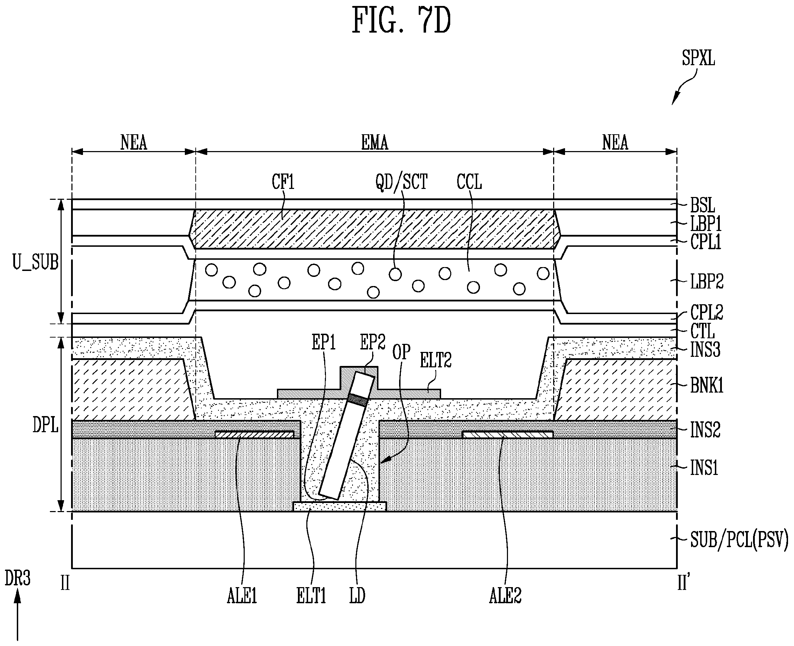

FIGS. 7B, 7C, and 7D are schematic cross-sectional views of the sub-pixel taken along line II-II' in FIG. 5B.

FIGS. 7C and 7D illustrate modified examples in relation to the position of a color conversion layer CCL. For example, an example in which the color conversion layer CCL is located at an upper portion of the display element layer DPL through a continuous process is illustrated in FIG. 7C, and an example in which an upper substrate U_SUB including the color conversion layer CCL is located on the display element layer DPL through an adhesion process using an intermediate layer CTL is illustrated in FIG. 7D. In relation to the examples shown in FIGS. 7B, 7C, and 7D, portions different from the portions of the above-described examples (e.g., the example shown in FIG. 7A) will be described. For convenience of descriptions, in FIGS. 7B, 7C, and 7D, components under the protective layer PSV are briefly expressed as the substrate SUB and/or the pixel circuit layer PCL (or the protective layer PSV).

Referring to FIGS. 7A and 7B, the sub-pixel SPXL may include a color conversion layer CCL located in the emission area EMA and a second bank BNK2 located in the non-emission area NEA.

The second bank BNK2 may be disposed on the third insulating layer INS3 (or the first bank BNK1) in the non-emission area NEA of the sub-pixel SPXL. In a plan view, the second bank BNK2 may surround the emission area EMA, and be a structure which finally defines the emission area EMA by defining a position at which the color conversion layer CCL is to be supplied. For example, the second bank BNK2 may be a structure which finally sets the emission area EMA by defining a position at which the color conversion layer CCL is supplied (or input) in the sub-pixel SPXL.

The second bank BNK2 may include a light blocking material. For example, the second bank BNK2 may be a black matrix. The second bank BNK2 may include at least one light blocking material and/or at least one reflective material, to allows light emitted from the color conversion layer CCL to further advance in an image display direction of the display device (or the third direction DR3), thereby improving light emission efficiency of the color conversion layer CCL.

The color conversion layer CCL may be disposed on (or on the top of) the second pixel electrode ELT₂ in the emission area EMA surrounded by the second bank BNK2.

The color conversion layer CCL may include color conversion particles QD (or wavelength conversion particles) corresponding to a specific color. For example, the color conversion layer CCL may include color conversion particles QD for converting light of a first color (or first wavelength band), which is emitted from the light emitting element LD, into light of a second color (specific color, or second wavelength band).

In the case that the sub-pixel SPXL (e.g., the first sub-pixel SPXL1 shown in FIG. 3) is a red pixel (or red sub-pixel), the color conversion layer CCL may include color conversion particles QD of a red quantum dot, which convert light of the first color, which is emitted from the light emitting elements LD, into light of a third color, e.g., light of red.

In the case that the sub-pixel SPXL (e.g., the second sub-pixel SPXL₂ shown in FIG. 3) is a green pixel (or green sub-pixel), the color conversion layer CCL may include color conversion particles QD of a green quantum dot, which convert light of the first color, which is emitted from the light emitting elements LD, into light of a fourth color, e.g., light of green.

In the case that the sub-pixel SPXL (e.g., the third sub-pixel SPXL₃ shown in FIG. 3) is a blue pixel (or blue sub-pixel), the color conversion layer CCL may include color conversion particles QD of a blue quantum dot, which convert light of the first color, which is emitted from the light emitting element LD, into light of a second color, e.g., light of blue.

In some implementations, in the case that the sub-pixel SPXL (e.g., the third sub-pixel SPXL₃ shown in FIG. 3) is a blue pixel (or blue sub-pixel), the sub-pixel SPXL may include a light scattering layer including light scattering particles SCT, instead of the color conversion layer CCL including the color conversion particles QD. For example, in the case that the light emitting elements LD emits blue light, the sub-pixel SPXL may include a light scattering layer including light scattering particles SCT. The above-described light scattering layer may be omitted. In other implementations, in the case that the sub-pixel SPXL is a blue pixel (or blue sub-pixel), a transparent polymer may be provided instead of the color conversion layer CCL.

A fourth insulating layer INS4 may be disposed over the color conversion layer CCL and the second bank BNK2.

The fourth insulating layer INS4 may be provided on an entire surface of the substrate SUB to entirely (or wholly) cover the second bank BNK2 and the color conversion layer CCL. The fourth insulating layer INS4 may be directly disposed over the second bank BNK2 and the color conversion layer CCL. The fourth insulating layer INS4 may be an inorganic layer including an inorganic material. The fourth insulating layer INS4 may include at least one of silicon nitride (SiNₓ), silicon oxide (SiOₓ), silicon oxynitride (SiOₓN_{y}), and metal oxide such as aluminum oxide (AlOₓ). The fourth insulating layer INS4 may entirely cover the second bank BNK2 and the color conversion layer CCL, thereby preventing external moisture, humidity, or the like from being introduced into the display element layer DPL.

The fourth insulating layer INS4 may reduce a step difference occurring due to components disposed on the bottom thereof, and have a flat surface. For example, the fourth insulating layer INS4 may be an organic layer including an organic material. The fourth insulating layer INS4 may be a common layer commonly provided in the display area DA (see FIG. 3), but the disclosure is not limited thereto.

A color filter layer CFL may be disposed on the fourth insulating layer INS4.

In the example shown in FIG. 7B, the color filter layer CFL may include a color filter corresponding to a color of each of the sub-pixels SPXL. For example, the color filter layer CFL may include a first color filter CF1 disposed on a color conversion layer CCL of a sub-pixel SPXL (e.g., the first sub-pixel SPXL₁ shown in FIG. 3), a second color filter CF2 disposed on a color conversion layer CCL of a sub-pixel SPXL (e.g. the second sub-pixel SPXL₂ shown in FIG. 3) adjacent to the sub-pixel SPXL in the first direction DR1, and a third color filter CF3 disposed on a color conversion layer CCL of a sub-pixel SPXL (e.g., the third sub-pixel SPXL₃ shown in FIG. 3) adjacent to the sub-pixel SPXL in the first direction DR1. The first, second, and third color filters CF1, CF2, and CF3 may be disposed to overlap with each other in the non-emission area NEA, to block light interference between adjacent sub-pixels SPXL. Each of the first, second, and third color filters CF1, CF2, and CF3 may include a color filter material for allowing light of a specific color, which is converted in the color conversion layer CCL, to selectively transmit therethrough. For example, the first color filter CF1 may be a red color filter, the second color filter CF2 may be a green color filter, and the third color filter CF3 may be a blue color filter. The above-described color filter CF may be provided on a surface of the fourth insulating layer INS4 to correspond to the color conversion layer CCL.

In the example shown in FIG. 7C, the color filter layer CFL may include a first color filter CF1 and a light blocking pattern LBP. The first color filter CF1 may be located in an emission area EMA of each of adjacent sub-pixels SPXL, and be disposed on the fourth insulating layer INS4 on the color conversion layer CCL of the corresponding sub-pixel SPXL. The light blocking pattern LBP may be located in the non-emission area NEA, and be disposed on the fourth insulating layer INS4 on the second bank BNK2 of the corresponding sub-pixel SPXL, e.g., the first sub-pixel SPXL₁ shown in FIG. 3. The light blocking pattern LBP may be located on a surface of the fourth insulating layer INS4 adjacent to the first color filter CF1. The light blocking pattern LBP may overlap the first and second banks BNK1 and BNK2 in the third direction DR3. The light blocking pattern LBP may include a light blocking material for preventing a light leakage defect in which light is leaked between adjacent sub-pixels. For example, the light blocking pattern LBP may include a black matrix. The light blocking pattern LBP may prevent color mixture of light emitted from each of adjacent sub-pixels SPXL.

An encap (encapsulation) layer ENC may be provided and/or formed on the color filter layer CFL.

The encap layer ENC may include a fifth insulating layer INS5. The fifth insulating layer INS5 may be an inorganic layer including an inorganic material or an organic layer including an organic material. The fifth insulating layer INS5 may entirely cover components located on the bottom thereof, thereby preventing external moisture, humidity, or the like from being introduced into the color filter layer CFL and the display element layer DPL.

In the display device including the sub-pixel SPXL, a color conversion layer CCL and a color filter CF may be disposed over a light emitting element LD, so that light having excellent color reproducibility may be emitted through the color conversion layer CCL and the color filter CF, thereby improving light emission efficiency.

The fifth insulating layer INS5 may be formed as a multi-layer. For example, the fifth insulating layer INS5 may include at least two inorganic layers and at least one organic layer interposed between the at least two inorganic layers. However, the material and/or structure of the fifth insulating layer INS5 may be variously changed. In some implementations, at least one overcoat layer, at least one filler layer, and/or an upper substrate may be further disposed on the top of the fifth insulating layer INS5.

In the above, it has been described that the color conversion layer CCL is formed directly over the second pixel electrode ELT2. However, the disclosure is not limited thereto. In some implementations, the color conversion layer CCL may be formed on a separate substrate, e.g., an upper substrate U_SUB as shown in FIG. 7D to be coupled to the display element layer DPL including the second pixel electrode ELT through an intermediate layer CTL or the like.

The intermediate layer CTL may be a transparent adhesive layer (or cohesive layer), e.g., optically clear adhesive for reinforcing adhesion between the display element layer DPL and the upper substrate U_SUB, but the disclosure is not limited thereto. In some implementations, the intermediate layer CTL may be a refractive index conversion layer for converting a refractive index of light which is emitted from light emitting elements LD and advances toward the upper substrate U_SUB, thereby improving the light emitting luminance of the sub-pixel PXL. The intermediate layer CTL may include a filler configured with an insulating material having insulative and adhesive properties.

The upper substrate U_SUB may constitute an encapsulation substrate and/or a window member of the display device. The upper substrate U_SUB may include a base layer BSL (or base substrate), a color conversion layer CCL, a first color filter CF1 (or color filter CF (see FIG. 7B)), first and second light blocking patterns LBP1 and LBP2, and first and second capping layers CPL1 and CPL2.

The base layer BSL may be a rigid substrate or a flexible substrate, and the material and property of the base layer BSL are not particularly limited. The base layer BSL and the substrate SUB may be configured with the same material or different materials.

In FIG. 7D, the color conversion layer CCL and the first color filter CF1 may be disposed on a surface of the base layer BSL to face the display element layer DPL. The first color filter CF1 may be provided on the surface of the base layer BSL to correspond to the color conversion layer CCL.

A first capping layer CPL1 may be provided and/or formed between the first color filter CF1 and the color conversion layer CCL.

The first capping layer CPL1 may be located over the first color filter CF1, thereby covering the first color filter CF1. Thus, the first capping layer CPL1 may protect the first color filter CF1. The first capping layer CPL1 may be an inorganic layer including an inorganic material or an organic layer including an organic material.

Light blocking patterns LBP1 and LBP2 may be located adjacent to the color conversion layer CCL and the first color filter CF1. The light blocking patterns LBP1 and LBP2 may be disposed on the surface of the base layer BSL in the non-emission area NEA of the sub-pixel SPXL. The light blocking patterns LBP1 and LBP2 may include a first light blocking pattern LBP1 and a second light blocking pattern LBP2.

The first light blocking pattern LBP1 may be located on the surface of the base layer BSL adjacent to the first color filter CF1.

The first capping layer CPL1 may be disposed on the first light blocking pattern LBP1.

The second light blocking pattern LBP2 may be disposed on a surface of the first capping layer CPL1 to correspond to the first light blocking pattern LBP1. The second light blocking pattern LBP2 may be a black matrix. The first light blocking pattern LBP1 and the second light blocking pattern LBP2 may include the same material. The second light blocking pattern LBP2 may be a structure defining the emission area EMA of the sub-pixel SPXL. The second light blocking pattern LBP2 may be a dam structure defining an emission area EMA to which a color conversion layer CCL is to be supplied in a process of supplying the color conversion layer CCL.

A second capping layer CPL2 may be entirely provided and/or formed over the color conversion layer CCL and the second light blocking pattern LBP2.

The second capping layer CPL2 may include at least one of silicon nitride (SiNₓ), silicon oxide (SiOₓ), silicon oxynitride (SiOₓN_{y}), and metal oxide such as aluminum oxide (AlOₓ), but the disclosure is not limited thereto. The second capping layer CPL2 may be configured as an organic layer including an organic material. The second capping layer CPL2 may be located over the color conversion layer CCL, thereby protecting the color conversion layer CCL from external moisture, humidity, and the like. Thus, the reliability of the color conversion layer CCL may be further improved.

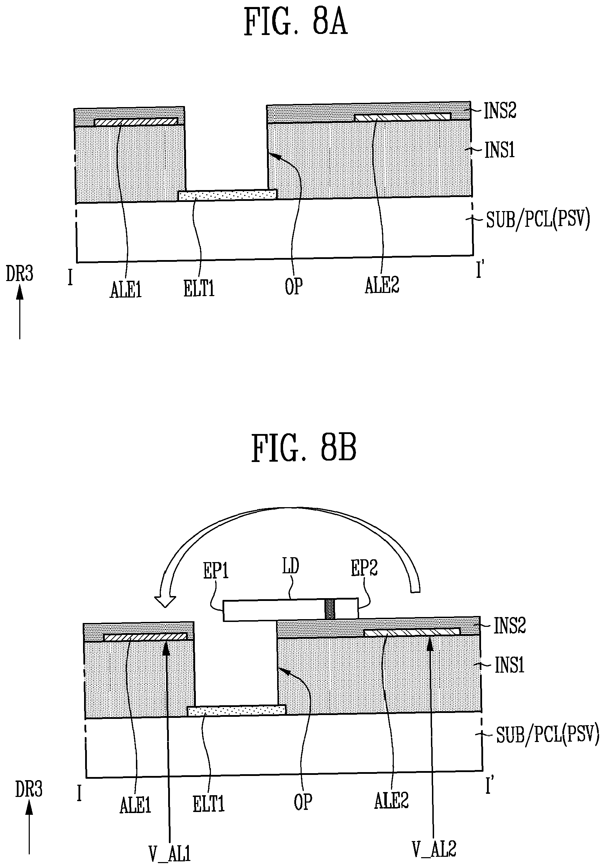

FIGS. 8A to 8E are views schematically illustrating a process of manufacturing the display device in FIG. 3. FIGS. 8A to 8E correspond to FIG. 6. For convenience of description, components under the protective layer PSV shown in FIG. 6 are briefly expressed as the substrate SUB and/or the pixel circuit layer PCL (or the protective layer PSV).

First, referring to FIGS. 6 and 8A, a first pixel electrode ELT₁ may be formed on a substrate SUB (a pixel circuit layer PCL, a protective layer PSV, or a base layer).

A first insulating layer INS1 may be formed over the first pixel electrode ELT₁. The first insulating layer INS1 may include an opening OP exposing the first pixel electrode ELT₁.

A first electrode ALE1 and a second electrode ALE2 spaced apart from each other with the opening OP interposed therebetween may be formed on the first insulating layer INS1. As described above, the first electrode ALE1 may be formed relatively adjacent to the opening OP, and the second electrode ALE2 may be formed to be spaced relatively apart from the opening OP. The first electrode ALE1 and the second electrode ALE2 may not overlap the first pixel electrode ELT1 in the third direction DR3, but the disclosure is not limited thereto. For example, the first electrode ALE1 may partially overlap the first pixel electrode ELT₁.

A second insulating layer INS2 may be formed on the first insulating layer INS1 to cover the first electrode ALE1 and the second electrode ALE2. The second insulating layer INS2 may include an opening corresponding to the opening OP of the first insulating layer INS1. The opening OP of the first insulating layer INS1 may be formed with the opening of the second insulating layer INS2 through different processes or the same process. The time at which each of the opening OP of the first insulating layer INS1 and the opening of the second insulating layer INS2 is formed is not particularly limited thereto. In some implementations, the process of forming the second insulating layer INS2 may be omitted.

The first bank BNK1 (see FIG. 7B) may be formed on the second insulating layer INS2.

Referring to FIG. 8B, a light emitting element LD may be supplied onto the second insulating layer INS2 (or the substrate SUB). For example, the light emitting element LD may be prepared in a form in which the light emitting element LD is dispersed in a solution (e.g., an ink), to be supplied to the emission area EMA of the sub-pixel SPXL shown in FIG. 7B through an inkjet printing process, a slit coating process, or the like.

At the same time as or after the supply of the light emitting element LD, an alignment signal or a first alignment signal V_AL1 and a second alignment signal V_AL2 may be primarily applied to the first electrode ALE1 and the second electrode ALE2. For example, the first alignment signal V_AL1 may be applied to the first electrode ALE1, and the second alignment signal V_AL2 may be applied to the second electrode ALE2. The first alignment signal V_AL1 may be an AC voltage, and the second alignment signal V_AL2 may be a ground voltage. However, the disclosure is not limited thereto.

In the case that the alignment signal is applied to the first electrode ALE1 and the second electrode ALE2, the light emitting element LD may be self-aligned between the first electrode ALE1 and the second electrode ALE2 as an electric field is formed between the first electrode ALE1 and the second electrode ALE2. For example, according to the electric field between the first electrode ALE1 and the second electrode ALE2, the light emitting element LD may be aligned between the first electrode ALE1 and the second electrode ALE2 such that a second end portion EP2 of the light emitting element LD faces the second electrode ALE2 and a first end portion EP1 of the light emitting element LD faces the first electrode ALE1. For example, the light emitting element LD may be primarily horizontally aligned between the first electrode ALE1 and the second electrode ALE2.

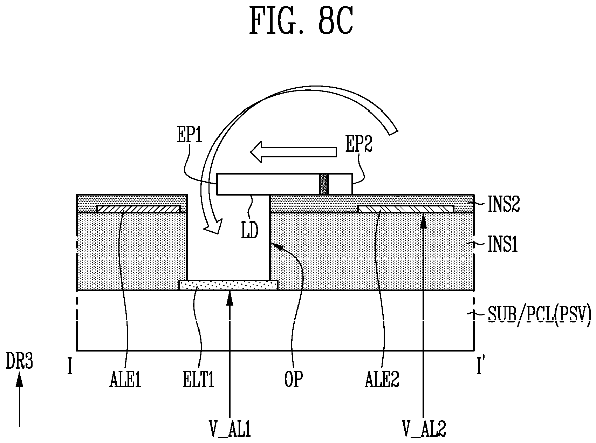

Referring to FIG. 8C, an alignment signal or a first alignment signal V_AL1 and a second alignment signal V_AL2 may be secondarily applied to the first pixel electrode ELT1 and the second electrode ALE2. For example, the first alignment signal V_AL1 may be applied to the first pixel electrode ELT1, and the second alignment signal V_AL2 may be applied to the second electrode ALE2. The first alignment signal V_AL1 may be not applied to the first electrode ALE1. The first alignment signal V_AL1 applied to the first pixel electrode ELT1 may be the same as the first alignment signal V_AL1 applied to the first electrode ALE1, but the disclosure is not limited thereto. For example, an alignment signal different from the first alignment signal V_AL1 applied to the first electrode ALE1 may be applied to the first pixel electrode ELT1.

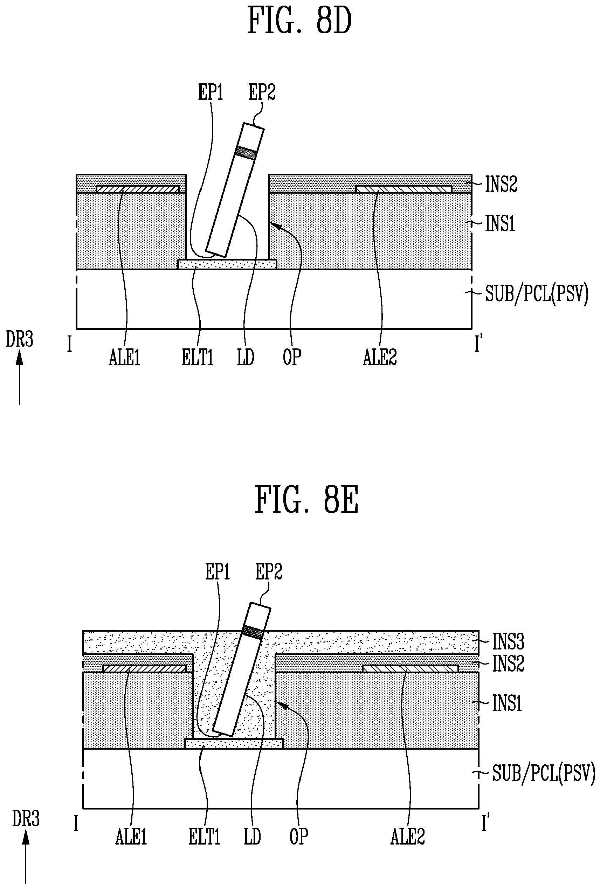

In case that the alignment signal is applied to the first pixel electrode ELT1 and the second electrode ALE2, the light emitting element LD may be aligned between the first pixel electrode ELT1 and the second electrode ALE2 as an electric field is formed between the first pixel electrode ELT1 and the second electrode ALE2. For example, according to the electric field formed in the vertical direction between the first pixel electrode ELT1 and the second electrode ALE2, the light emitting element LD may rotate (or be located) toward the first pixel electrode ELT1. Accordingly, as shown in FIG. 8D, the light emitting element LD may be located in the opening OP of the first insulating layer INS1, and be vertically aligned by the first insulating layer INS1. For example, the light emitting element LD may be secondarily vertically aligned on the first pixel electrode ELT1.

After the light emitting element LD is aligned, a solvent may be volatilized or removed through another process.

Referring to FIG. 8E, a third insulating layer INS3 may be formed on the second insulating layer INS2 (or the substrate SUB). The third insulating layer INS3 may fix the light emitting element LD as being filled in the opening OP of the first insulating layer INS1. The third insulating layer INS3 may be formed with a thickness such that the second end portion EP2 is exposed.

Referring to FIG. 6, a second pixel electrode ELT2 may be formed on the second end portion EP2 of the light emitting element LD, which is exposed by the third insulating layer INS3.

In some implementations, the color conversion layer CCL described with reference to FIGS. 7B, 7C, and 7D may be formed or disposed on the substrate SUB.

As described above, the light emitting element LD may be horizontally aligned by using the first electrode ALE1 and the second electrode ALE2 and be vertically aligned in the opening OP of the first insulating layer INS1 by using the first pixel electrode ELT1 and the second electrode ALE2.

Thus, the display device including the vertically aligned light emitting element LD may be readily manufactured without any facilities for vertically arranging the light emitting element LD and transferring and bonding the light emitting element LD onto the substrate SUB.

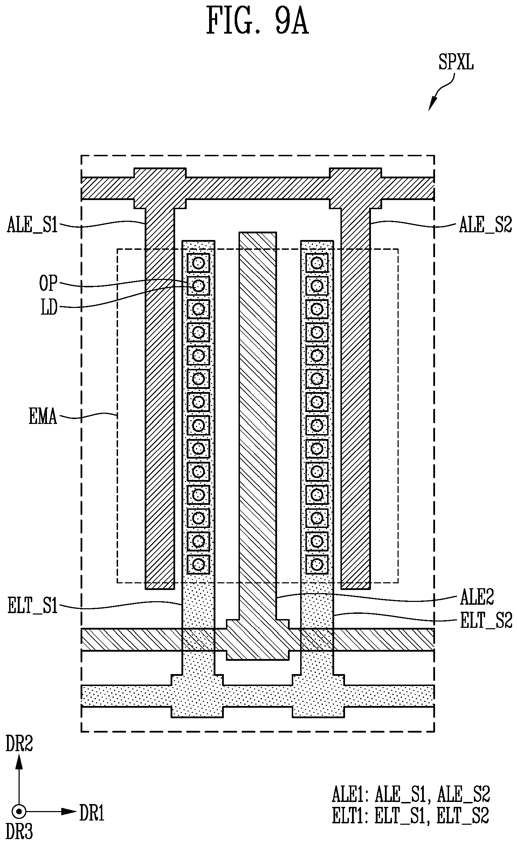

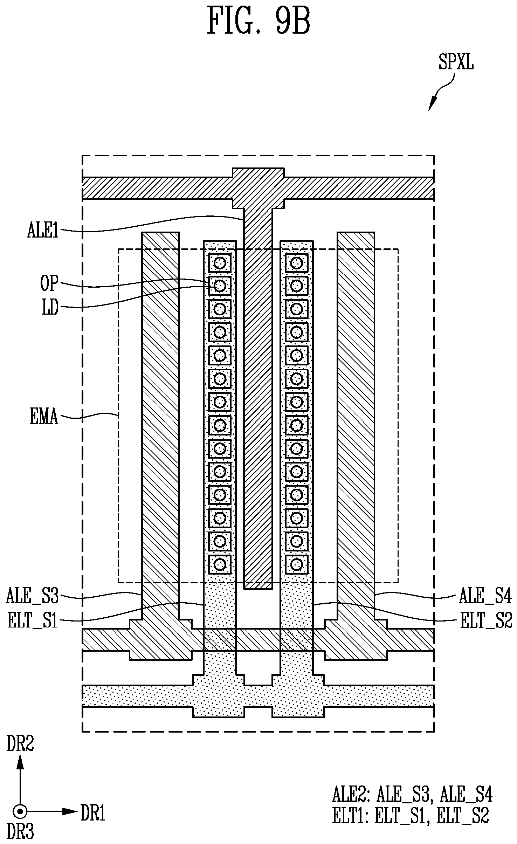

FIGS. 9A and 9B are plan views of the sub-pixel included in the display device in FIG. 3. FIGS. 9A and 9B may correspond to FIG. 5A. For convenience of description, the second pixel electrode ELT2 shown in FIG. 5B is omitted. However, the second pixel electrode ELT2 shown in FIG. 5B may be applied to FIGS. 9A and 9B. For example, a sub-pixel SPXL may further include a second pixel electrode ELT2 overlapping the first pixel electrode ELT1.

First, referring to FIGS. 5A and 9A, a first pixel electrode ELT1 may include a first sub-pixel electrode ELT_S1 and a second sub-pixel electrode ELT_S2.

In a plan view, each of the first sub-pixel electrode ELT_S1 and the second sub-pixel electrode ELT_S2 may extend in the second direction DR2 in an emission area EMA, and the first sub-pixel electrode ELT_S1 and the second sub-pixel electrode ELT_S2 may be disposed to be spaced apart from each other in the first direction DR1 with a second electrode ALE2 interposed therebetween. The first sub-pixel electrode ELT_S1 and the second sub-pixel electrode ELT_S2 may be connected to each other.

A first electrode ALE1 may include a first sub-electrode ALE_S1 and a second sub-electrode ALE_S2. In a plan view, each of the first sub-electrode ALE_S1 and the second sub-electrode ALE_S2 may extend in the second direction DR2 in the emission area EMA. The first sub-electrode ALE_S1 may be spaced apart from the second electrode ALE2 with the first sub-pixel electrode ELT_S1 interposed therebetween, and the second sub-electrode ALE_S2 may be spaced apart from the second electrode ALE2 with the second sub-pixel electrode ELT_S2 interposed therebetween.

The first sub-pixel electrode ELT_S1 may be disposed more adjacent to the first sub-electrode ALE_S1 than to the second electrode ALE2, and the second sub-pixel electrode ELT_S2 may be disposed more adjacent to the second sub-electrode ALE_S2 than to the second electrode ALE2.

An opening OP (i.e., the opening of the first insulating layer INS1 (see FIG. 6)) may be formed to overlap the first sub-pixel electrode ELT_S1 and the second sub-pixel electrode ELT_S2, and a light emitting element LD may be located in the opening OP.

As compared with FIG. 5A, a larger number of light emitting elements LD may be provided in the sub-pixel SPXL in FIG. 9A.

Referring to FIG. 5A and 9B, in a plan view, the first sub-pixel electrode ELT_S1 and the second sub-pixel electrode ELT_S2 may be disposed to be spaced apart from each other in the first direction DR1 with the first electrode ALE1 interposed therebetween.

The second electrode ALE2 may include a third sub-electrode ALE_S3 and a fourth sub-electrode ALE_S4. In a plan view, each of the third sub-electrode ALE_S3 and the fourth sub-electrode ALE_S4 may extend in the second direction DR2 in the emission area EMA. The third sub-electrode ALE_S3 may be spaced apart from the first electrode ALE1 with the first sub-pixel electrode ELT_S1 interposed therebetween, and the fourth sub-electrode ALE_S4 may be spaced apart from the first electrode ALE1 with the second sub-pixel electrode ELT_S2 interposed therebetween.

The first sub-pixel electrode ELT_S1 may be disposed more adjacent to the first electrode ALE1 than to the third sub-electrode ALE_S3. The second sub-pixel electrode ELT_S2 may be disposed more adjacent to the first electrode ALE1 than to the fourth sub-electrode ALE_S4.

The example shown in FIG. 9A and the example shown in FIG. 9B may be combined with each other.

As described above, at least one of the first pixel electrode ELT1, the first electrode ALE1, and the second electrode ALE2 may include multiple sub-electrodes.

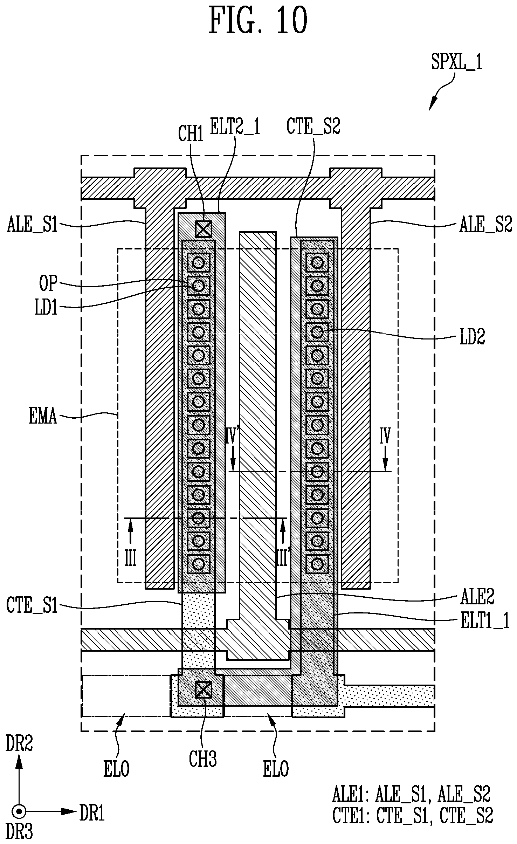

FIG. 10 is a plan view of the sub-pixel included in the display device in FIG. 3. FIG. 10 may correspond to FIG. 9A. In FIG. 10, a sub-pixel SPXL_1 is briefly illustrated based on the light emitting part EMU (see FIG. 4B).

Referring to FIGS. 3, 9A, and 10, the sub-pixel SPXL_1 shown in FIG. 10 may be substantially identical or similar to the sub-pixel SPXL shown in FIG. 9A, except a first intermediate electrode CTE1, a first pixel electrode ELT1_1, and a second pixel electrode ELT2_1. The first pixel electrode ELT1_1 and the second pixel electrode ELT2_1 may be substantially identical or similar to the first pixel electrode ELT1 and the second pixel electrode ELT2, which are shown in FIGS. 5B and 5C, respectively. Therefore, overlapping descriptions will not be repeated.

The first pixel electrode ELT1_1 and the second pixel electrode ELT2_1 may be disposed to be spaced apart from each other with a second electrode ALE2 interposed therebetween. As described with reference to FIG. 4B, the first pixel electrode ELT1_1 and the second pixel electrode ELT2_1 may constitute different serial stages, and may not overlap with each other. The first pixel electrode ELT1_1 may be disposed between the second electrode ALE2 and a second sub-electrode ALE_S2, and the second pixel electrode ELT2_1 may be disposed between the second electrode ALE2 and a first sub-electrode ALE_S1.

The first intermediate electrode CTE1 may include a first sub-intermediate electrode CTE_S1 and a second sub-intermediate electrode CTE_S2.

The first sub-intermediate electrode CTE_S1 may overlap the second pixel electrode ELT2_1 in the third direction DR3. A first light emitting element LD1 may be disposed to overlap the first sub-intermediate electrode CTE_S1 and the second pixel electrode ELT2_1 in the third direction DR3. As described with reference to FIG. 4B, the first sub-intermediate electrode CTE_S1, the second pixel electrode ELT2_1, and the first light emitting element LD1 connected therebetween may constitute the first serial stage SET1 (see FIG. 4B). A cross-sectional view taken along line III-III' shown in FIG. 10 may be identical to the cross-sectional view shown in FIG. 6, and the first sub-intermediate electrode CTE_S1 shown in FIG. 10 may correspond to the first pixel electrode ELT1 in FIG. 6. Therefore, descriptions of the cross-sectional view taken along line III-III' shown in FIG. 10 will be omitted.

The second sub-intermediate electrode CTE_S2 may overlap the first pixel electrode ELT1_1 in the third direction DR3. A second light emitting element LD2 may be disposed to overlap the second sub-intermediate electrode CTE_S2 and the first pixel electrode ELT1_1 in the third direction DR3. As described with reference to FIG. 4B, the second sub-intermediate electrode CTE_S2, the first pixel electrode ELT1_1, and the second light emitting element LD2 connected therebetween may constitute the second serial stage SET2 (see FIG. 4B). A cross-sectional view taken along line IV-IV' shown in FIG. 10 may be substantially identical to the cross-sectional view shown in FIG. 6, and the second sub-intermediate electrode CTE_S2 shown in FIG. 10 may correspond to the second pixel electrode ELT2 in FIG. 6. Therefore, descriptions of the cross-sectional view taken along line IV-IV' shown in FIG. 10 will be omitted.

The second sub-intermediate electrode CTE_S2 may partially overlap the first sub-intermediate electrode CTE_S1, and be in contact with or electrically connected to the first sub-intermediate electrode CTE_S1 through a third contact hole CH3. The first light emitting element LD1 and the second light emitting element LD2 may be connected in series between the second pixel electrode ELT2_1 and the first pixel electrode ELT1_1 through the first sub-intermediate electrode CTE_S1 and the second sub-intermediate electrode CTE_S2, i.e., the first intermediate electrode CTE1.

The first sub-intermediate electrode CTE_S1 and the first pixel electrode ELT1_1 may include the same material and be disposed in the same layer. For example, the first sub-intermediate electrode CTE_S1 and the first pixel electrode ELT1_1 may be simultaneously formed through the same process. For example, one electrode layer including the first sub-intermediate electrode CTE_S1 and the first pixel electrode ELT1_1 may be formed, and an opening part ELO may be removed, so that the first sub-intermediate electrode CTE_S1 and the first pixel electrode ELT1_1, which are separated from each other, are formed.

The second sub-intermediate electrode CTE_S2 and the second pixel electrode ELT2_1 may include the same material and be disposed in the same layer. For example, the second sub-intermediate electrode CTE_S2 and the second pixel electrode ELT2_1 may be simultaneously formed through the same process. For example, one electrode layer including the second sub-intermediate electrode CTE_S2 and the second pixel electrode ELT2_1 may be formed, and the second sub-intermediate electrode CTE_S2 and the second pixel electrode ELT2_1, which are separated from each other, may be formed through patterning on an electrode layer.

As described above, the sub-pixel SPXL_1 may include the first light emitting element LD1 and the second light emitting element LD2, which are electrically connected in series to each other.

Although a case where the sub-pixel SPXL_1 includes two serial stages has been illustrated in FIG. 10, the disclosure is not limited thereto. The number of serial stages included in the sub-pixel SPXL_1 may be variously changed. For example, the sub-pixel SPXL_1 may include three, four, five or more serial stages by combining the above-described examples (e.g., the examples shown in FIG. 5B, 10, and the like).

In the display device in accordance with the disclosure, the display device may include a light emitting element vertically aligned in an opening of an organic layer formed over a first pixel electrode. Light emitted from the light emitting element in a vertical direction may advance in the vertical direction as it is, so that light emission efficiency may be improved.

In the manufacturing method of the display device in accordance with the disclosure, a light emitting element may be primarily horizontally aligned by using first and second electrodes located in the same layer. The light emitting element may be vertically aligned by using a first pixel electrode and a second electrode, which are located in different layers. Thus, the display device including the vertically aligned light emitting element may be readily manufactured.

The above description is an example of technical features of the disclosure, and those skilled in the art to which the disclosure pertains will be able to make various modifications and variations. Therefore, the embodiments of the disclosure described above may be implemented separately or in combination with each other.

Therefore, the embodiments disclosed in the disclosure are not intended to limit the disclosure, but to describe the invention, and the scope of the invention is not limited by these embodiments, but is defined by the claims.

## Claims

1. A display device comprising:
a first pixel electrode disposed on a base layer;
a first insulating layer disposed on the first pixel electrode and including an opening exposing the first pixel electrode;
a first electrode and a second electrode disposed on the first insulating layer and spaced apart from each other with the opening disposed between the first electrode and the second electrode;
a light emitting element disposed in the opening and including a first end portion electrically contacting the first pixel electrode and a second end portion;
a second insulating layer covering the first insulating layer, the first electrode, and the second electrode and exposing the second end portion of the light emitting element; and
a second pixel electrode disposed on the second insulating layer and electrically contacting the second end portion of the light emitting element.

2. The display device of claim 1, wherein
the light emitting element includes a contact electrode layer, an n-type semiconductor layer, an active layer, and a p-type semiconductor layer, which are sequentially stacked, and
the contact electrode layer electrically contacts the first pixel electrode,
the p-type semiconductor layer electrically contacts the second pixel electrode,
the first pixel electrode is a cathode electrode, and
the second pixel electrode is an anode electrode.

3. The display device of claim 1 or 2, wherein
the opening is disposed closer to the first electrode than to the second electrode in a plan view,
the thickness of the first insulating layer in a cross-sectional view is in a range of about 40% to about 75% of the length of the light emitting element,
the width of the opening in a plan view is in a range of about 40% to about 75% of the length of the light emitting element,
a plurality of openings are formed in the first insulating layer and arranged in an extending direction of the first pixel electrode, and
the distance between adjacent ones of the plurality of openings is in a range of about 40% to about 75% of the length of the light emitting element.

4. The display device of any one of the preceding claims, wherein the distance between the first electrode and the second electrode is in a range of about 80% to about 120% of a length of the light emitting element.

5. The display device of any one of the preceding claims, wherein the second insulating layer is filled in the opening of the first insulating layer.

6. The display device of any one of the preceding claims, further comprising:
a third insulating layer disposed between the first and second electrodes and the second insulating layer.

7. The display device of any one of the preceding claims, further comprising:
a bank disposed between the first and second electrodes and the second insulating layer, the bank defining an emission area in a plan view.

8. The display device of any one of the preceding claims, further comprising:
color conversion particles disposed on the second pixel electrode, the color conversion particles converting a wavelength band of light emitted from the light emitting element.

9. The display device of claim 8, further comprising:
a color filter disposed on the color conversion particles.

10. The display device of any one of the preceding claims, wherein
the first pixel electrode includes a first sub-pixel electrode and a second sub-pixel electrode, spaced apart from each other with the second electrode disposed between the first sub-pixel electrode and the second sub-pixel electrode in a plan view and electrically connected with each other, and
the first electrode includes a first sub-electrode spaced apart from the second electrode with the first sub-pixel electrode disposed between the first sub-electrode and the second electrode in a plan view and a second sub-electrode spaced apart from the second electrode with the second sub-pixel electrode disposed between the second sub-electrode and the second electrode.

11. A method of manufacturing a display device, the method comprising:
forming a first pixel electrode on a base layer;
forming, on the base layer, a first insulating layer including an opening exposing the first pixel electrode;
forming, on the first insulating layer, a first electrode and a second electrode spaced apart from each other with the opening disposed between the first electrode and the second electrode;
supplying a light emitting element onto the base layer;
aligning the light emitting element between the first electrode and the second electrode by primarily applying a first alignment signal to the first electrode and the second electrode;
locating the light emitting element in the opening of the first insulating layer by secondarily applying a second alignment signal to the first pixel electrode and the second electrode; and
forming a second pixel electrode on the light emitting element.

12. The method of claim 11, further comprising:
forming a second insulating layer in the opening of the first insulating layer before the forming of the second pixel electrode, the second insulating layer exposing an end portion of the light emitting element,
wherein the second pixel electrode is disposed on the second insulating layer.

13. The method of claim 12, further comprising:
forming a third insulating layer covering the first electrode and the second electrode, before the forming of the second insulating layer,
wherein the second insulating layer covers the third insulating layer.

14. The method of claim 12 or 13, further comprising:
forming a bank on the first insulating layer, before the forming of the second insulating layer,
wherein the bank defines an emission area in a plan view.

15. The method of any one of claims 11 to 14, further comprising:
forming, on the second pixel electrode, color conversion particles converting a wavelength band of light emitted from the light emitting element; and
forming a color filter on the color conversion particles.
